# EUROPEAN PATENT APPLICATION

(11) **EP 4 580 333 A1**
(43) Date of publication of application: **02.07.2025**
(21) Application number: 24211792.7
(22) Date of filing: 08.11.2024
(51) Int. Cl.: H10D 30/01, H10D 62/13, H10D 64/01, H10D 64/23, H01L 21/28, H01L 21/283, B82Y 10/00

(54) **BACKSIDE EPITAXIAL GROWTH FOR IMPROVED CONTACT AREA**

(30) Priority: 29.12.2023 US 202318400310
(71) Applicant: Intel Corporation, Santa Clara, CA 95054 (US)
(72) Inventor: Kobrinsky, Mauro J., Portland, 97229 (US); Mannebach, Ehren, Portland, 97007 (US); Mills, Shaun, Hillsboro, 97124 (US); Silva, Joseph D., Hillsboro, 97124 (US); Desai, Umang, Portland, 97225 (US)
(74) Representative: Goddar, Heinz J.

(57) **Abstract**

Techniques are provided to form an integrated circuit having backside epaxially grown source or drain regions in addition to the frontside source or drain regions to reduce backside contact resistance. A semiconductor device includes a gate structure around or otherwise on a semiconductor region. The gate structure includes a gate dielectric and a gate electrode. The substrate beneath the semiconductor device may be removed from the backside to expose a subfin region beneath the semiconductor region. The subfin region may be removed using a backside etch to open a backside recess that exposes a bottom surface of a given frontside source or drain region. A backside source or drain region may be grown on a bottom surface of the given frontside source or drain region and remain within the backside recess or extend out of the backside recess.

## Description

### BACKGROUND

As integrated circuits continue to scale downward in size, a number of challenges arise. For instance, reducing the size of memory and logic cells can respectively reduce the contact area for certain elements. Reduced contact area can lead to increased resistance, which may result in slower switching speeds or low device yield. Some existing processes to form contacts to certain structures only expose a portion of the structure, thus increasing the contact resistance. Accordingly, there remain a number of non-trivial challenges with respect to forming such high-density semiconductor devices.

### BRIEF DESCRIPTION OF THE DRAWINGS

Figure 1A is an isometric view of an integrated circuit structure that includes additional epitaxial source or drain growth on the backside to improve backside contact area to the source or drain regions, in accordance with an embodiment of the present disclosure.
Figures 1B and 1C are different cross-sectional views of the integrated circuit of Figure 1A that show the additional source or drain growth on the backside of the structure, in accordance with an embodiment of the present disclosure.
Figures 2A and 2B are cross-sectional views that illustrate one stage in an example process for forming an integrated circuit configured with backside epitaxial source or drain formation to reduce backside contact resistance, in accordance with an embodiment of the present disclosure.
Figures 3A and 3B are cross-sectional views that illustrate another stage in the example process for forming an integrated circuit configured with backside epitaxial source or drain formation to reduce backside contact resistance, in accordance with an embodiment of the present disclosure.
Figures 4A and 4B are cross-sectional views that illustrate another stage in the example process for forming an integrated circuit configured with backside epitaxial source or drain formation to reduce backside contact resistance, in accordance with an embodiment of the present disclosure.
Figures 5A and 5B are cross-sectional views that illustrate another stage in the example process for forming an integrated circuit configured with backside epitaxial source or drain formation to reduce backside contact resistance, in accordance with an embodiment of the present disclosure.
Figures 6A and 6B are cross-sectional views that illustrate another stage in the example process for forming an integrated circuit configured with backside epitaxial source or drain formation to reduce backside contact resistance, in accordance with an embodiment of the present disclosure.
Figures 7A and 7B are cross-sectional views that illustrate another stage in the example process for forming an integrated circuit configured with backside epitaxial source or drain formation to reduce backside contact resistance, in accordance with an embodiment of the present disclosure.
Figures 8A and 8B are cross-sectional views that illustrate another stage in the example process for forming an integrated circuit configured with backside epitaxial source or drain formation to reduce backside contact resistance, in accordance with an embodiment of the present disclosure.
Figures 9A and 9B are cross-sectional views that illustrate another stage in the example process for forming an integrated circuit configured with backside epitaxial source or drain formation to reduce backside contact resistance, in accordance with an embodiment of the present disclosure.
Figures 10A and 10B are cross-sectional views that illustrate another stage in the example process for forming an integrated circuit configured with backside epitaxial source or drain formation to reduce backside contact resistance, in accordance with an embodiment of the present disclosure.
Figures 11A and 11B are cross-sectional views that illustrate another stage in the example process for forming an integrated circuit configured with backside epitaxial source or drain formation to reduce backside contact resistance, in accordance with an embodiment of the present disclosure.
Figures 12A and 12B are cross-sectional views that illustrate another stage in the example process for forming an integrated circuit configured with backside epitaxial source or drain formation to reduce backside contact resistance, in accordance with an embodiment of the present disclosure.
Figures 13A and 13B are cross-sectional views that illustrate another stage in the example process for forming an integrated circuit configured with backside epitaxial source or drain formation to reduce backside contact resistance, in accordance with an embodiment of the present disclosure.
Figures 14A and 14B are cross-sectional views that illustrate another stage in the example process for forming an integrated circuit configured with backside epitaxial source or drain formation to reduce backside contact resistance, in accordance with an embodiment of the present disclosure.

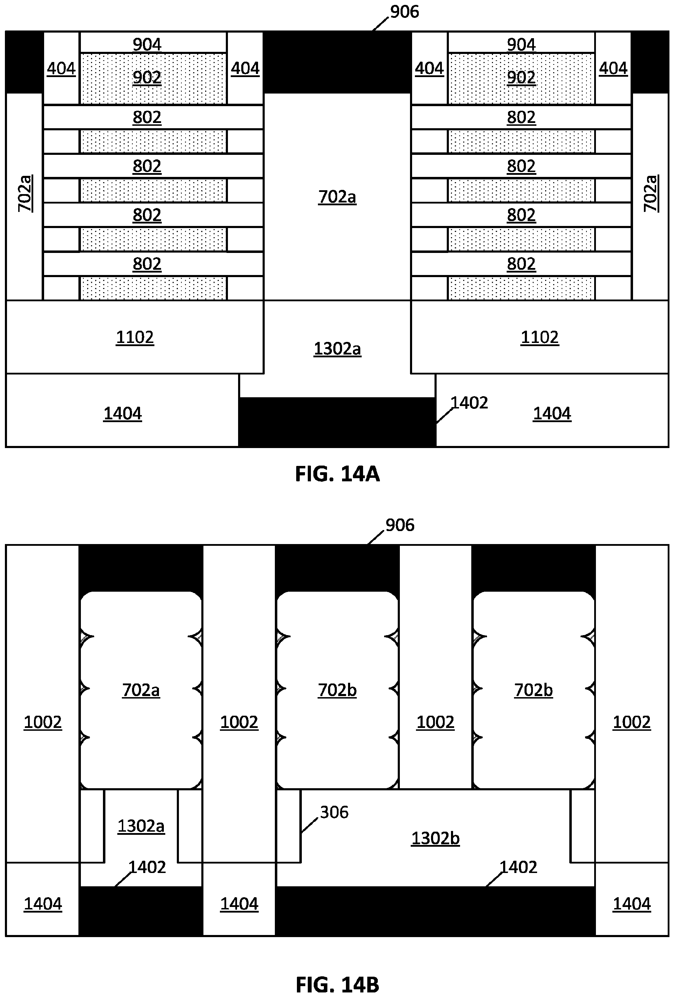

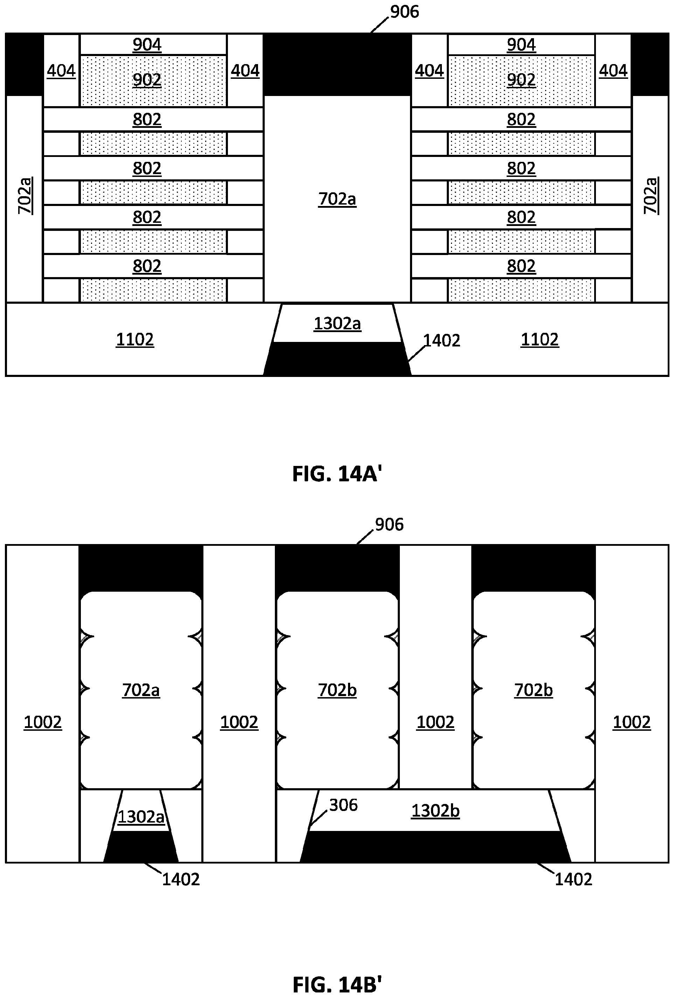

Figures 14A' and 14B' are cross-sectional views that illustrate another example of an integrated circuit configured with backside epitaxial source or drain formation to reduce backside contact resistance, in accordance with an embodiment of the present disclosure.

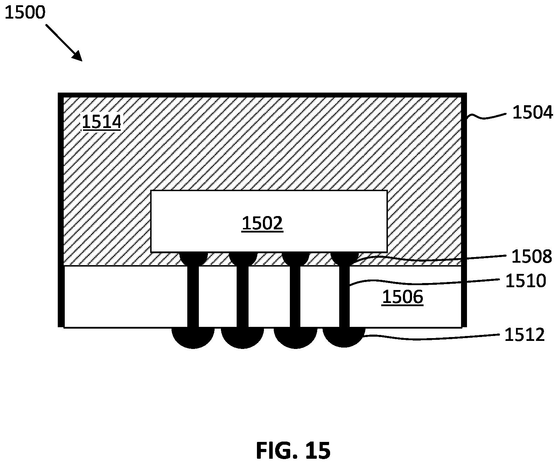

Figure 15 illustrates a cross-sectional view of a chip package containing one or more semiconductor dies, in accordance with some embodiments of the present disclosure.

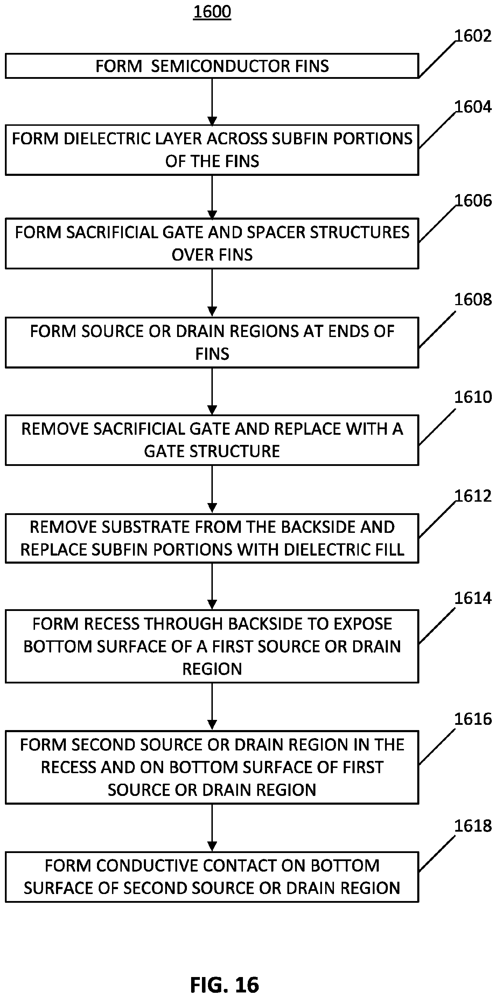

Figure 16 is a flowchart of a fabrication process for a semiconductor device having backside epitaxial source or drain formation to reduce backside contact resistance, in accordance with an embodiment of the present disclosure.

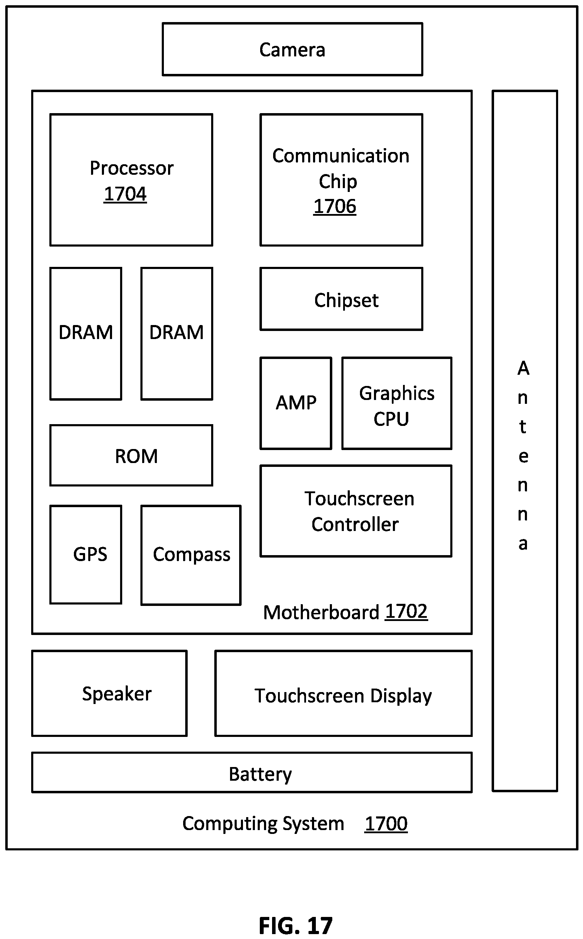

Figure 17 illustrates a computing system including one or more integrated circuits, as variously described herein, in accordance with an embodiment of the present disclosure.

Although the following Detailed Description will proceed with reference being made to illustrative embodiments, many alternatives, modifications, and variations thereof will be apparent in light of this disclosure. As will be further appreciated, the figures are not necessarily drawn to scale or intended to limit the present disclosure to the specific configurations shown. For instance, while some figures generally indicate perfectly straight lines, right angles, and smooth surfaces, an actual implementation of an integrated circuit structure may have less than perfect straight lines, right angles (e.g., some features may have tapered sidewalls and/or rounded corners), and some features may have surface topology or otherwise be non-smooth, given real world limitations of the processing equipment and techniques used.

### DETAILED DESCRIPTION

Techniques are provided herein to form an integrated circuit having backside epaxially grown source or drain regions in addition to the frontside source or drain regions to reduce backside contact resistance. The techniques can be used in any number of integrated circuit applications and are particularly useful with respect to logic and memory cells, such as those cells that use finFETs, gate-all-around transistors (e.g., ribbonFETs and nanowire FETs), or forksheet transistors. In an example, a semiconductor device includes a gate structure around or otherwise on a semiconductor region. The semiconductor region can be, for example, a fin of semiconductor material that extends from a first source or drain region to a second source or drain region, or one or more nanowires, nanoribbon, or nanosheets of semiconductor material that extend from a first source or drain region to a second source or drain region. The gate structure includes a gate dielectric (e.g., high-k gate dielectric material) and a gate electrode (e.g., conductive material such as workfunction material and/or gate fill metal). The substrate beneath the semiconductor device may be removed from the backside to expose a subfin region beneath the semiconductor region. The subfin region may be removed using a backside etch to open a backside recess that exposes a bottom surface of a given source or drain region. A backside source or drain region may be grown within the backside recess and merged with the given source or drain region. The backside source or drain region may continue to grow out beyond the walls of the backside recess, thus increasing the available backside contact area for the given source or drain region coupled with the backside source or drain region. Additionally, the backside source or drain region may include a higher dopant concentration than the given source or drain region to decrease the resistivity of the region. Numerous variations and embodiments will be apparent in light of this disclosure.

### General Overview

As previously noted above, there remain a number of non-trivial challenges with respect to integrated circuit fabrication. In more detail, backside interconnects have become increasingly more popular to route power and ground rails beneath the source or drain regions of various transistors. To make contact to a given source or drain region, a portion of a subfin, or a sacrificial material beneath the source or drain region, is removed from the backside and a contact is formed within the opening. These backside contacts are often made small to avoid potentially shorting with the adjacent gate structures. However, such contacts only land upon a portion of the lower surface of the source or drain region, which increases the contact resistance.

Thus, and in accordance with an embodiment of the present disclosure, techniques are provided herein to expand the backside surface of source or drain regions to increase the contact area. According to some embodiments, the backside or lower surface of a frontside source or drain region can be exposed following the removal of the substrate and a backside cavity etch to expose the frontside source or drain region. The backside cavity etch may form a backside well or cavity over the lower surface of the frontside source or drain region. Another epitaxial growth process may be performed to grow a backside source or drain region within the backside cavity beneath the frontside source or drain region. The backside source or drain region can grow up and out of the backside cavity to increase the total contact area. Furthermore, the backside source or drain region may be more heavily doped compared to the frontside source or drain region, which can further decrease the contact resistance.

The backside source or drain region may match the dopant type of the frontside source or drain region. Accordingly, a p-type frontside source or drain region would have a p-type backside source or drain region and a n-type frontside source or drain region would have a n-type backside source or drain region. Additionally, the same materials may be used to promote a more robust growth between the frontside source or drain region and backside source or drain region. In some examples, both n-type regions may include silicon doped with phosphorous or both p-type regions may include silicon germanium doped with boron. A n-type frontside source or drain region may have a dopant concentration between about 4×10²⁰ - 6×10²⁰ cm⁻³ while a n-type backside source or drain region may have a dopant concentration between about 7×10²⁰ - 8×10²⁰ cm⁻³. According to some embodiments, a p-type frontside source or drain region has a dopant concentration between about 2×10²¹ - 3×10²¹ cm⁻³ while a p-type backside source or drain region has a dopant concentration between about 3×10²¹ - 4×10²¹ cm⁻³.

According to an embodiment, an integrated circuit includes one or more semiconductor bodies extending in a first direction from a first source or drain region, a gate structure extending over the one or more semiconductor bodies in a second direction different from the first direction, a dielectric layer beneath the gate structure, and a second source or drain region contacting a bottom surface of the first source or drain region, such that a seam is present between the first source or drain region and the second source or drain region. The second source or drain region contacts a sidewall of the dielectric layer.

According to another embodiment, an integrated circuit includes one or more semiconductor bodies extending in a first direction from a first source or drain region, a gate structure extending over the one or more semiconductor bodies in a second direction different from the first direction, a dielectric layer beneath the gate structure, and a second source or drain region contacting a bottom surface of the first source or drain region. The second source or drain region has a higher n-type dopant concentration or a higher p-type dopant concentration compared to the first source or drain region.

According to another embodiment, a method of forming an integrated circuit includes: forming a fin having semiconductor material extending in a first direction over a substrate; forming a dielectric layer adjacent to a bottom portion of the fin; forming a sacrificial gate and spacers on sidewalls of the sacrificial gate, the sacrificial gate extending in a second direction over the fin, the second direction being different from the first direction; removing an exposed portion of the fin adjacent to the sacrificial gate; forming a first source or drain region coupled to an end of the fin; replacing the sacrificial gate with a gate structure; removing the substrate from the backside of the integrated circuit; forming a recess on the backside to expose a bottom surface of the first source or drain region; and forming a second source or drain region within the recess and on the bottom surface of the first source or drain region; and forming a conductive backside contact on a bottom surface of the second source or drain region.

The techniques can be used with any type of non-planar transistors, including finFETs (sometimes called double-gate transistors, or tri-gate transistors), or nanowire and nanoribbon transistors (sometimes called gate-all-around transistors), or stacked versions of any of these architectures, to name a few examples. The source and drain regions can be, for example, doped portions of a given fin or substrate or epitaxial regions that are deposited during an etch-and-replace source/drain forming process. The dopant type in the source and drain regions will depend on the polarity of the corresponding transistor. The gate structure can be implemented with a gate-first process or a gate-last process (sometimes called a replacement metal gate, or RMG, process), or any other gate formation process. Any number of semiconductor materials can be used in forming the transistors, such as group IV materials (e.g., silicon, germanium, silicon germanium) or group III-V materials (e.g., gallium arsenide, indium gallium arsenide).

Use of the techniques and structures provided herein may be detectable using tools such as electron microscopy including scanning/transmission electron microscopy (SEM/TEM), scanning transmission electron microscopy (STEM), nano-beam electron diffraction (NBD or NBED), and reflection electron microscopy (REM); composition mapping; x-ray crystallography or diffraction (XRD); energy-dispersive x-ray spectroscopy (EDX); secondary ion mass spectrometry (SIMS); time-of-flight SIMS (ToF-SIMS); atom probe imaging or tomography; local electrode atom probe (LEAP) techniques; 3D tomography; or high resolution physical or chemical analysis, to name a few suitable example analytical tools. For instance, in some example embodiments, such tools may indicate the presence of a first source or drain region coupled to the semiconductor region and a second source or drain region grown beneath and contacting the first source or drain region. A visible seam may be present between the first and second source or drain regions. Analysis of the two regions may be performed to indicate that the dopant concentration (n-type or p-type) is higher in the second source or drain compared to the first source or drain region.

It should be readily understood that the meaning of "above" and "over" in the present disclosure should be interpreted in the broadest manner such that "above" and "over" not only mean "directly on" something but also include the meaning of over something with an intermediate feature or a layer therebetween. Further, spatially relative terms, such as "beneath," "below," "lower," "above," "upper," "top," "bottom," and the like, may be used herein for ease of description to describe one element or feature's relationship to another element (s) or feature (s) as illustrated in the figures. The spatially relative terms are intended to encompass different orientations of the device in use or operation in addition to the orientation depicted in the figures. The apparatus may be otherwise oriented (rotated 90 degrees or at other orientations) and the spatially relative descriptors used herein may likewise be interpreted accordingly.

As used herein, the term "layer" refers to a material portion including a region with a thickness. A monolayer is a layer that consists of a single layer of atoms of a given material. A layer can extend over the entirety of an underlying or overlying structure, or may have an extent less than the extent of an underlying or overlying structure. Further, a layer can be a region of a homogeneous or inhomogeneous continuous structure, with the layer having a thickness less than the thickness of the continuous structure. For example, a layer can be located between any pair of horizontal planes between, or at, a top surface and a bottom surface of the continuous structure. A layer can extend horizontally, vertically, and/or along a tapered surface. A layer can be conformal to a given surface (whether flat or curvilinear) with a relatively uniform thickness across the entire layer.

Materials that are "compositionally different" or "compositionally distinct" as used herein refers to two materials that have different chemical compositions. This compositional difference may be, for instance, by virtue of an element that is in one material but not the other (e.g., SiGe is compositionally different than silicon), or by way of one material having all the same elements as a second material but at least one of those elements is intentionally provided at a different concentration in one material relative to the other material (e.g., SiGe having 70 atomic percent germanium is compositionally different than from SiGe having 25 atomic percent germanium). In addition to such chemical composition diversity, the materials may also have distinct dopants (e.g., gallium and magnesium) or the same dopants but at differing concentrations. In still other embodiments, compositionally distinct materials may further refer to two materials that have different crystallographic orientations. For instance, (110) silicon is compositionally distinct or different from (100) silicon. Creating a stack of different orientations could be accomplished, for instance, with blanket wafer layer transfer. If two materials are elementally different, then one of the material has an element that is not in the other material.

### Architecture

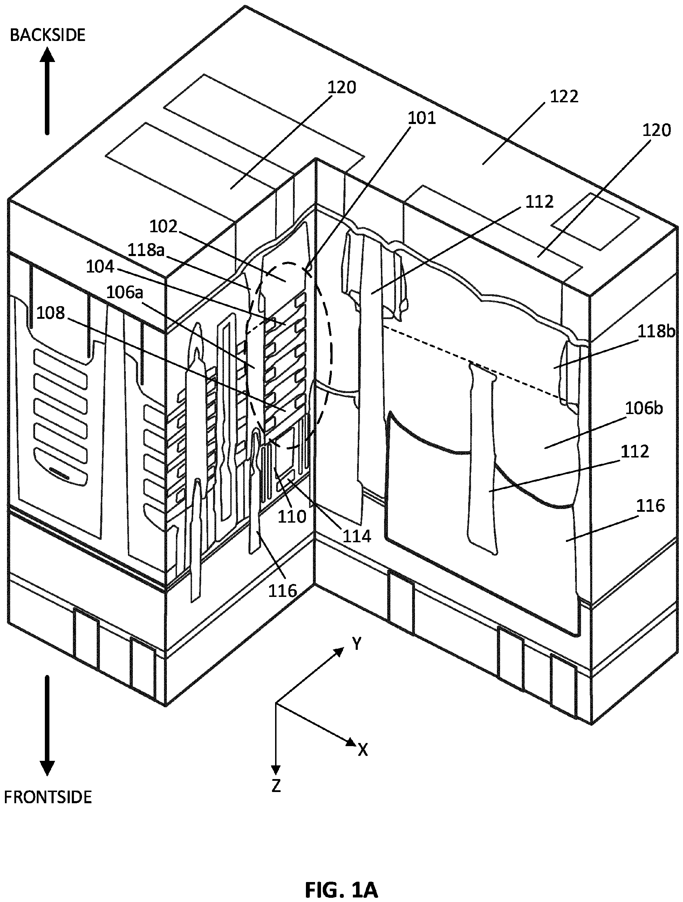

Figure 1A is an isometric view of a portion of an integrated circuit that includes various semiconductor devices 101, in accordance with an embodiment of the present disclosure. Each of the semiconductor devices may be non-planar metal oxide semiconductor (MOS) transistors, such as tri-gate (e.g., finFET), gate-all-around (GAA), or forksheet transistors, although other transistor topologies and types could also benefit from the techniques provided herein. The examples herein illustrate semiconductor devices with a GAA structure (e.g., having nanoribbons or nanowires that extend between source and drain regions). Note that the structure in Figure 1A is flipped upside down such that the backside of the structure is on top and the frontside of the structure is on the bottom.

The semiconductor material used in each of the semiconductor devices may be formed from a semiconductor substrate. In some embodiments, the substrate is removed from the backside and replaced with any number of dielectric layers to form backside interconnects beneath various transistor elements. In the example illustrated in Figure 1A, a base dielectric layer 102 may be formed beneath semiconductor devices 101. In some examples, subfin portions of semiconductor devices 101 are removed from the backside and replaced with dielectric material. One or more additional dielectric layers may be formed beneath base dielectric layer 102 to form backside interconnects, as will be discussed in more detail herein.

The one or more semiconductor regions of the devices may include fins that can be, for example, native to the substrate (formed from the substrate itself), such as silicon fins etched from a bulk silicon substrate. Alternatively, the fins can be formed of material deposited onto the substrate. In one such example case, a blanket layer of silicon germanium (SiGe) can be deposited onto a silicon substrate, and then patterned and etched to form a plurality of SiGe fins extending from that substrate. In still other embodiments, the fins include alternating layers of material (e.g., alternating layers of silicon and SiGe) that facilitates forming of nanowires and nanoribbons during a gate forming process where one type of the alternating layers is selectively etched away so as to liberate the other type of alternating layers within the channel region, so that a gate-all-around process can then be carried out. Again, the alternating layers can be blanket deposited and then etched into fins or deposited into fin-shaped trenches.

Each semiconductor device 101 includes one or more semiconductor regions, such as one or more nanoribbons 104 extending between epitaxial source or drain regions 106a/106b in a first direction along the X-axis. According to some embodiments, source or drain regions 106a represent n-type or p-type regions while source or drain regions 106b represent the opposite dopant type from source or drain regions 106a. In some examples, n-type source or drain regions include silicon doped with phosphorous or arsenic, and p-type source or drain regions include silicon germanium doped with boron. Other examples may be configured differently.

A gate structure 108 that includes a gate electrode and a gate dielectric extends over the one or more semiconductor regions of a given semiconductor device 101 in a second direction along the Y-axis to form the transistor gate. The gate electrode may represent any number of conductive layers and the gate dielectric may represent any number of dielectric layers. The gate electrode may include any sufficiently conductive material such as a metal, metal alloy, or doped polysilicon. In some embodiments, the gate electrode includes one or more workfunction metals around the one or more semiconductor regions. The gate electrode may also include a fill metal or other conductive material around the workfunction metals to provide the whole gate electrode structure. The gate dielectric may include any gate dielectric material(s). In some embodiments, the gate dielectric includes a layer of native oxide material (e.g., silicon oxide) on the nanoribbons 104 or other semiconductor regions, and a layer of high-k dielectric material (e.g., hafnium oxide) on the native oxide. According to some embodiments, spacer structures 110 are present along the sidewalls of gate structures 108. Spacer structures 110 may be any dielectric material, such as silicon nitride or silicon oxynitride, and provide separation between a given gate structure 108 and the adjacent source or drain region 106a/106b and contacts 116. Spacer structures 110 may run along sidewalls of gate structure 108 in the second direction and extend the entire height of gate structure 108 along the Z-axis. In this example, spacer structures 110 generally include both the upper spacers (sometimes called gate spacers, which may be formed during dummy or initial gate formation) and lower spacers (sometimes called inner gate spacers, which may be formed during source/drain processing).

According to some embodiments, adjacent gate structures 108 may be separated from one another along the second direction (e.g., along the Y-axis) by a dielectric wall 112 (sometimes referred to as a gate cut). Any number of suitable dielectric materials can be used for dielectric wall 112, such as silicon nitride or silicon oxynitride or low-k versions of these (e.g., porous silicon oxynitride). Any number of dielectric walls 112 may run lengthwise parallel to one another along the X-axis and may extend along the Z-axis at least through an entire thickness of one or more gate structures 108 and up to (or through) a cap layer 114 on a top surface of gate structures 108, as shown in this example. According to some embodiments, dielectric wall 112 continues to extend along the X-axis between multiple pairs of semiconductor devices and between the source or drain regions 106a/106b of the devices.

Dielectric cap layer 114 may run lengthwise along the Y-axis along the top surface of gate structures 108 and be interrupted by dielectric wall 112. Cap layer 114 may include the same dielectric material as dielectric wall 112, in some examples.

As further shown in the example of Figure 1A, any number of frontside conductive contacts 116 are on corresponding source or drain regions 106a/106b. Adjacent frontside conductive contacts 116 may be separated by dielectric wall 112 or may connect together over or through dielectric wall 112 (e.g., via a bridging conductor). Frontside conductive contacts 116 can include any suitable conductive material, such as tungsten, ruthenium, cobalt, molybdenum, titanium, tantalum, or other metals or alloys thereof. Frontside conductive contacts 116 may be formed together such that they include the same conductive material.

As further shown in the example of Figure 1A, backside source or drain regions 118a/118b are provided directly beneath the corresponding frontside source or drain regions 106a/106b. The dotted lines across both the X and Y directions are used to roughly differentiate between the frontside and backside source/drain regions. According to some embodiments, backside source or drain regions 118a/118b are grown from within recesses formed on the backside of the structure which expose the bottom surfaces of source or drain regions 106a/106b. Accordingly, a seam may be present between backside source or drain regions 118a/118b and frontside source or drain regions 106a/106b where two different epitaxial growth processes occur. Backside source or drain regions 118a/118b may have the same dopant type as their corresponding frontside source or drain regions 106a/106b. In some embodiments, backside source or drain regions 118a/118b connect between adjacent source or drain regions 106a/106b, such as shown in the example structure of Figure 1A for backside source or drain region 118b, which connects two corresponding frontside source or drain regions 106b that were otherwise separated by dielectric wall 112.

According to some embodiments, backside source or drain regions 118a/118b have a higher n-type or p-type dopant concentration compared to their corresponding frontside source or drain regions 106a/106b. For example, a n-type frontside source or drain region 106a may have a dopant concentration between about 4×10²⁰ - 6×10²⁰ cm⁻³ while a n-type backside source or drain 118a region may have a dopant concentration between about 7×10²⁰ - 8×10²⁰ cm⁻³; and a p-type frontside source or drain region 106b may have a dopant concentration between about 2×10²¹ - 3×10²¹ cm⁻³ while a p-type backside source or drain region 118b may have a dopant concentration between about 3×10²¹ - 4×10²¹ cm⁻³. Other doping schemes may be used as well.

Backside source or drain regions 118a/118b may extend out and over a portion of the lower surface of base dielectric layer 102, thus increasing the contact area for the overall source or drain structure. According to some embodiments, one or more backside conductive contacts 120 are formed on the lower surface of backside source or drain regions 118a/118b. Backside conductive contacts 120 may include any of the same materials noted above for frontside conductive contacts 116. In some examples, backside conductive contacts 120 and frontside conductive contacts 116 include the same conductive material. Backside conductive contacts 120 may connect to backside power or ground rails, or to a signal routing interconnect structure. According to some embodiments, backside conductive contacts 120 are formed through a backside dielectric layer 122. Backside dielectric layer 122 may represent any number of different dielectric layers and may include any suitable dielectric material, such as silicon dioxide. According to some embodiments, additional dielectric layers and conductive elements can be formed beneath backside dielectric layer 122 to create a backside interconnect structure (such as a power delivery network and/or signal routing network).

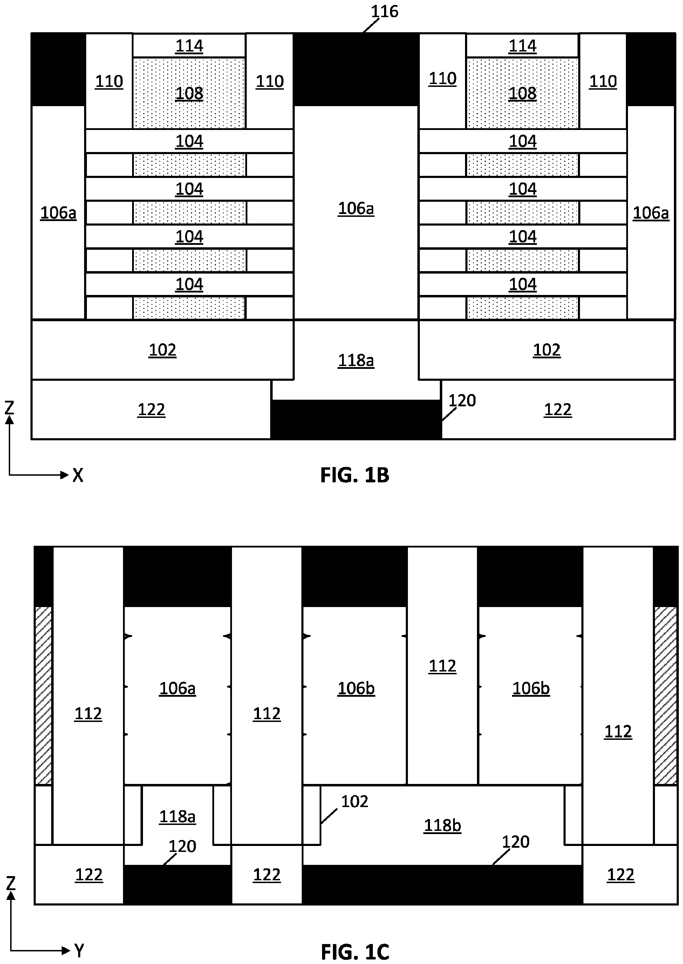

Figure 1B illustrates a cross-section view across the XZ plane from Figure 1A and Figure 1C illustrates a cross-section view across the YZ plane from Figure 1A, according to some embodiments. In either or both directions, note how backside source or drain regions 118a/118b may be configured to increase the contact surface area for backside conductive contacts 120. In more detail, the contact surface area is increased due to backside source or drain regions 118a/118b extending out and over the bottom surface of base dielectric layer 102. In some examples, backside source or drain regions 118a/118b do not extend below the bottom surface of base dielectric layer 102, but a taper of the sidewalls of the recess in which contacts 120 sit may be provisioned so as to provide an increase in the backside contact area for backside source or drain regions 118a/118b.

### Fabrication Methodology

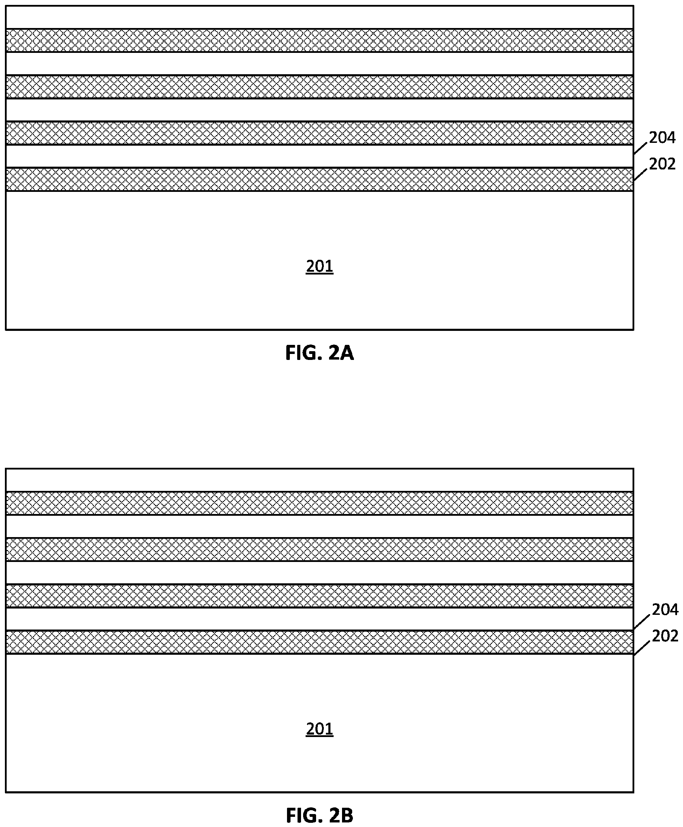

Figures 2A - 14A and 2B - 14B include cross-sectional views that collectively illustrate an example process for forming an integrated circuit configured with backside source or drain regions, in accordance with an embodiment of the present disclosure. Figures 2A - 14A represent a similar cross-sectional view taken across the XZ plane in Figure 1A, while Figures 2B - 14B represent a cross-sectional view taken across the YZ in Figure 1A. Each set of figures sharing the same letter shows an example structure that results from the process flow up to that point in time, so the depicted structure evolves as the process flow continues, culminating in the structure shown in Figures 14A - 14B (or Figures 14A' - 14B'), which is similar to the structure shown in Figures 1B and 1C. Such a structure may be part of an overall integrated circuit (e.g., such as a processor or memory chip) that includes, for example, digital logic cells and/or memory cells and analog mixed signal circuitry. Thus, the illustrated integrated circuit structure may be part of a larger integrated circuit that includes other integrated circuitry not depicted. Example materials and process parameters are given, but the present disclosure is not intended to be limited to any specific such materials or parameters, as will be appreciated.

Figures 2A and 2B each illustrates a cross-sectional view taken through a substrate 201 having a series of material layers formed over the substrate, according to an embodiment of the present disclosure. Alternating material layers may be deposited over a substrate 201 including sacrificial layers 202 alternating with semiconductor layers 204. The alternating layers are used to form GAA transistor structures. Any number of alternating sacrificial layers 202 and semiconductor layers 204 may be deposited over substrate 201.

Substrate 201 can be, for example, a bulk substrate including group IV semiconductor material (such as silicon, germanium, or silicon germanium), group III-V semiconductor material (such as gallium arsenide, indium gallium arsenide, or indium phosphide), and/or any other suitable material upon which transistors can be formed. Alternatively, substrate 201 can be a semiconductor-on-insulator substrate having a desired semiconductor layer over a buried insulator layer (e.g., silicon over silicon dioxide). Alternatively, substrate 201 can be a multilayer substrate or superlattice suitable for forming nanowires or nanoribbons (e.g., alternating layers of silicon and SiGe, or alternating layers indium gallium arsenide and indium phosphide). Any number of substrates can be used.

According to some embodiments, semiconductor layers 204 have a different material composition than sacrificial layers 202. In some embodiments, semiconductor layers 204 are silicon germanium (SiGe) while sacrificial layers 202 include a semiconductor material suitable for use as a nanoribbon such as silicon (Si), SiGe, germanium, or III-V materials like indium phosphide (InP) or gallium arsenide (GaAs). In examples where SiGe is used in each of semiconductor layers 204 and in sacrificial layers 202, the germanium concentration is different between semiconductor layers 204 and sacrificial layers 202. For example, semiconductor layers 204 may include a higher germanium content compared to sacrificial layers 202. In some examples, sacrificial layers 202 may be doped with either n-type dopants (to produce a p-channel transistor) or p-type dopants (to produce an n-channel transistor).

While dimensions can vary from one example embodiment to the next, the thickness of each semiconductor layer 204 may be between about 5 nm and about 20 nm. In some embodiments, the thickness of each semiconductor layer 204 is substantially the same (e.g., within 1-2 nm). The thickness of each of sacrificial layers 202 may be about the same as the thickness of each semiconductor layer 204 (e.g., about 5-20 nm). Each of semiconductor layers 204 and sacrificial layers 202 may be deposited using any known material deposition technique, such as chemical vapor deposition (CVD), plasma-enhanced chemical vapor deposition (PECVD), physical vapor deposition (PVD), or atomic layer deposition (ALD), or epitaxial growth.

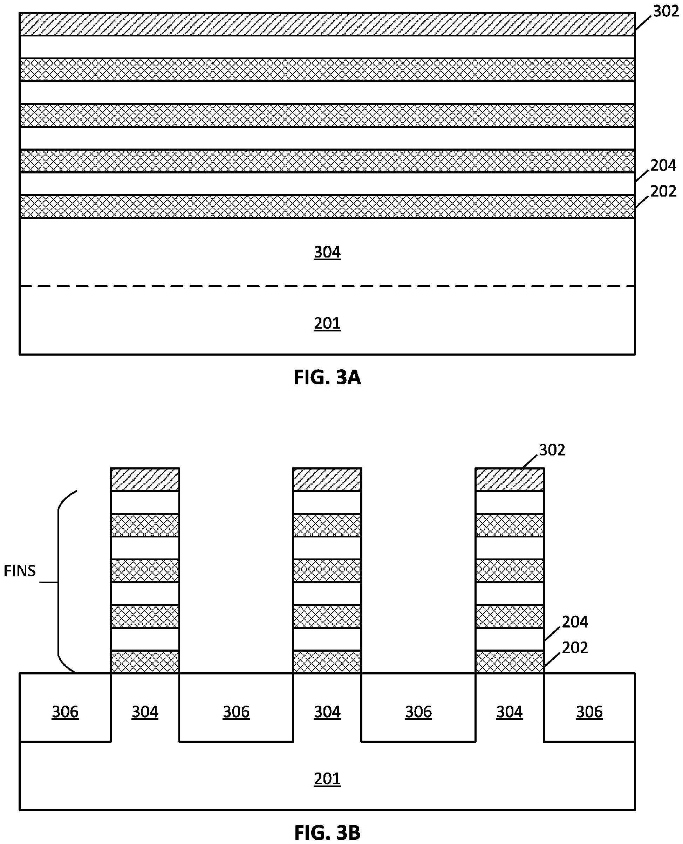

Figures 3A and 3B depict the cross-section views of the structure shown in Figures 2A and 2B, respectively, following the formation of a cap layer 302 and the subsequent formation of fins beneath cap layer 302, according to an embodiment. Cap layer 302 may be any suitable hard mask material such as a carbon hard mask (CHM) or silicon nitride. Cap layer 302 is patterned into rows to form corresponding rows of fins from the alternating layer stack of sacrificial layers 202 and semiconductor layers 204. Cap layer 302 extends along the top of each fin in a first direction, as seen in Figure 3A.

According to some embodiments, an anisotropic etching process through the layer stack continues into at least a portion of substrate 201. Portions of substrate 201 beneath the fins are not etched and yield subfin regions 304. The etched portion of substrate 201 may be filled with a dielectric fill 306 that acts as shallow trench isolation (STI) between adjacent fins. Dielectric fill 306 may be any dielectric material such as silicon oxide. Subfin regions 304 represent remaining portions of substrate 201 between dielectric fill 306, according to some embodiments.

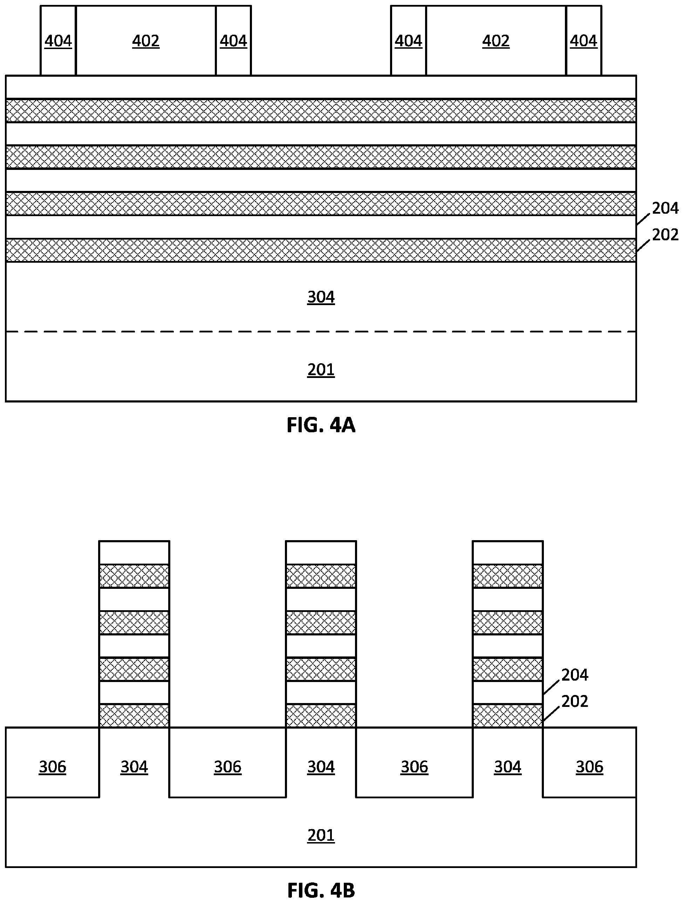

Figures 4A and 4B depict cross-section views of the structures shown in Figures 3A and 3B following the formation of sacrificial gates 402, according to some embodiments. A gate masking layer may first be patterned in strips that extend orthogonally across each of the fins (e.g., in a second direction) in order to form corresponding sacrificial gates 402 in strips beneath the gate masking layers. Afterwards, the gate masking layers may be removed or may remain as a cap layer above each sacrificial gate 402. According to some embodiments, the sacrificial gate material is removed in all areas not protected by the gate masking layers. Sacrificial gate 402 may be any material that can be selectively removed without damaging the semiconductor material of the fins. In some examples, sacrificial gate 402 includes polysilicon.

According to some embodiments, spacer structures 404 (also referred to as gate spacers or upper gate spacers) are formed along the sidewalls of sacrificial gates 402. Spacer structures 404 may be deposited and then etched back such that spacer structures 404 remain mostly only on sidewalls of any exposed structures. In the cross-section view of Figure 4B, spacer structures 404 may also be formed along sidewalls of the exposed fins over dielectric fill 306. Such sidewall spacers on the fins can be removed during later processing when forming the source or drain regions, but as shown in this example may also remain in the final structure. According to some embodiments, spacer structures 404 may be any suitable dielectric material, such as silicon nitride, silicon carbon nitride, or silicon oxycarbonitride. In one such embodiment, spacer structures 404 comprise a nitride and dielectric fill 306 comprises an oxide, so as to provide a degree of etch selectivity during final gate processing. Other etch selective dielectric schemes (e.g., oxide/carbide, carbide/nitride) can be used as well for spacer structures 404 and dielectric fill 306. In other embodiments, spacer structures 404 and dielectric fill 306 are compositionally the same or otherwise similar, where etch selectivity is not employed.

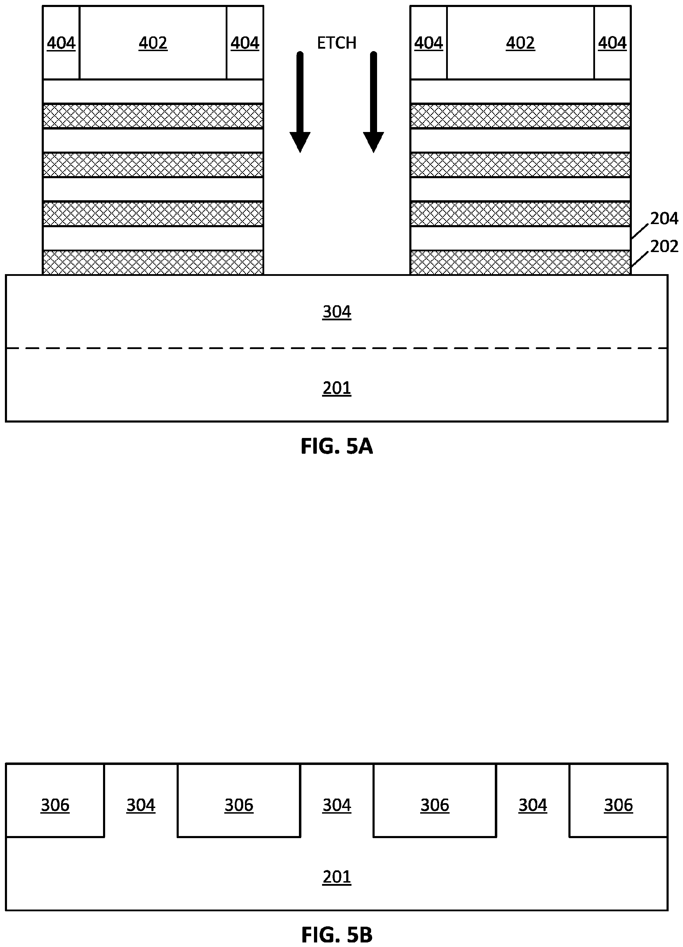

Figures 5A and 5B depict cross-section views of the structures shown in Figures 4A and 4B following the removal of exposed portions of the fins not protected by sacrificial gates 402 and spacer structures 404, according to some embodiments. The exposed fin portions may be removed using any anisotropic etching process, such as reactive ion etching (RIE). The removal of the exposed fin portions creates source or drain trenches that alternate with gate trenches (currently filled with sacrificial gates 402) along the first direction, according to some embodiments. In some embodiments, at least a portion of subfin regions 304 are also removed such that a top surface of subfin regions 304 is recessed below a top surface of dielectric fill 306. The recessed area above subfin regions 304 may be filled with one or more dielectric materials. In some embodiments, the recessed area between dielectric fill 306 is replaced with a sacrificial material (such as aluminum oxide) that can be removed at a later time from the backside to expose the underside of source or drain regions.

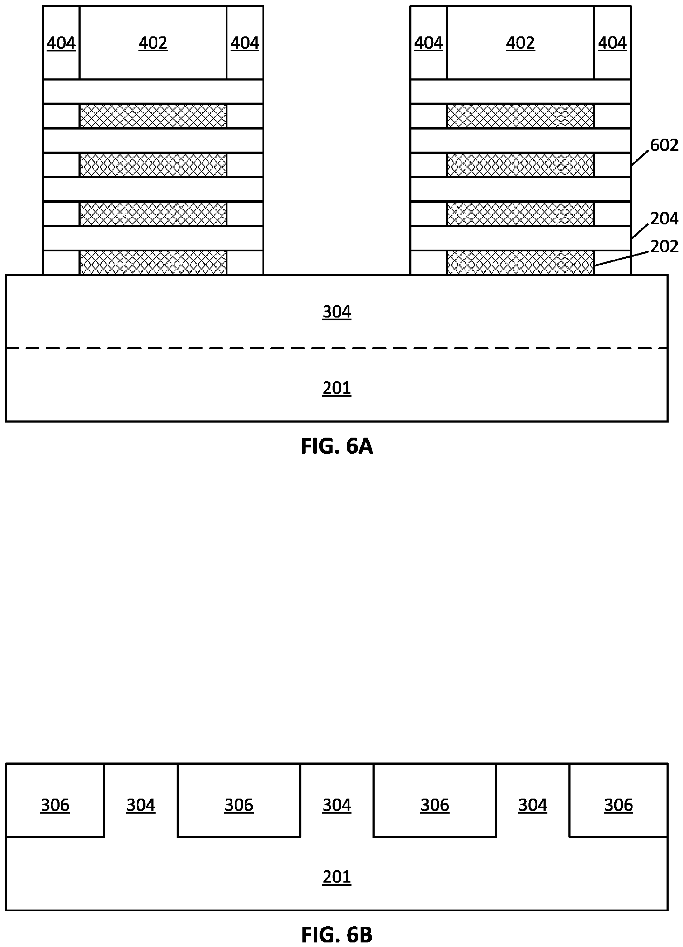

Figures 6A and 6B depict cross-section views of the structures shown in Figures 5A and 5B following the removal of portions of sacrificial layers 202 and subsequent formation of internal spacers 602 (sometimes called lower gate spacers), according to an embodiment of the present disclosure. An isotropic etching process may be used to selectively recess the exposed ends of each sacrificial layer 202 (e.g., while etching comparatively little of semiconductor layers 204). Internal spacers 602 may have a material composition that is similar to or the exact same as spacer structures 404. Accordingly, internal spacers 602 may be any dielectric material that exhibits high etch selectively to semiconductor materials such as silicon and/or silicon germanium. Internal spacers 602 may be, for example, conformally deposited over the sides of the fin structure using a conformal deposition process like CVD or ALD and then etched back using an isotropic etching process to expose the ends of semiconductor layers 204. According to some embodiments, internal spacers 602 have a similar width (e.g., along the first direction) to spacer structures 404.

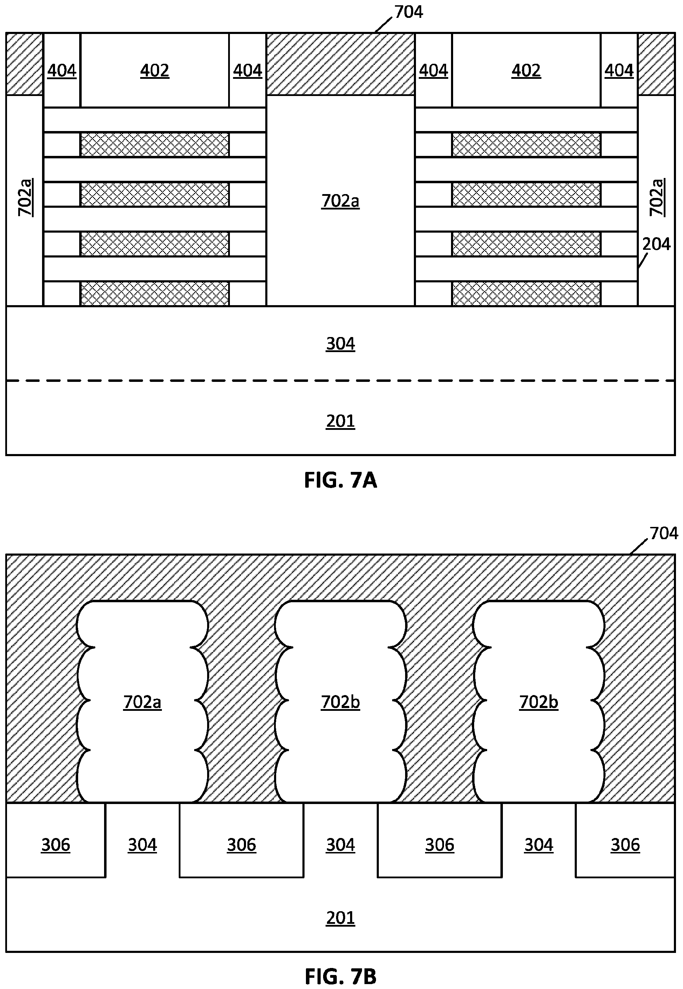

Figures 7A and 7B depict cross-section views of the structure shown in Figures 6A and 6B, respectively, following the formation of source or drain regions 702a/702b within the source/drain trenches, according to some embodiments. Source or drain regions 702a/702b may be formed in the areas that had been previously occupied by the exposed fins between spacer structures 404. According to some embodiments, source or drain regions 702a/702b are epitaxially grown from the exposed semiconductor material at the ends of semiconductor layers 204. In some example embodiments, source or drain regions 702a are NMOS source or drain regions (e.g., epitaxial silicon) while source or drain regions 702b are PMOS source or drain regions (e.g., epitaxial SiGe), or vice versa. Accordingly, source or drain regions of one dopant type may be formed first before the formation of source or drain regions of the other dopant type.

According to some embodiments, a dielectric fill 704 is provided between adjacent source or drain regions 702a/702b. In some examples, dielectric fill 704 occupies a remaining volume within the source/drain trench around and over source or drain regions 702a/702b. Dielectric fill 704 may be any dielectric material, such as silicon dioxide. In some examples, dielectric fill 704 extends up to and planar with a top surface of spacer structures 404 (e.g., following a polishing procedure). A planarization process such as chemical mechanical polish (CMP) can be used to remove any excess dielectric fill 704 and planarize the structure, as shown.

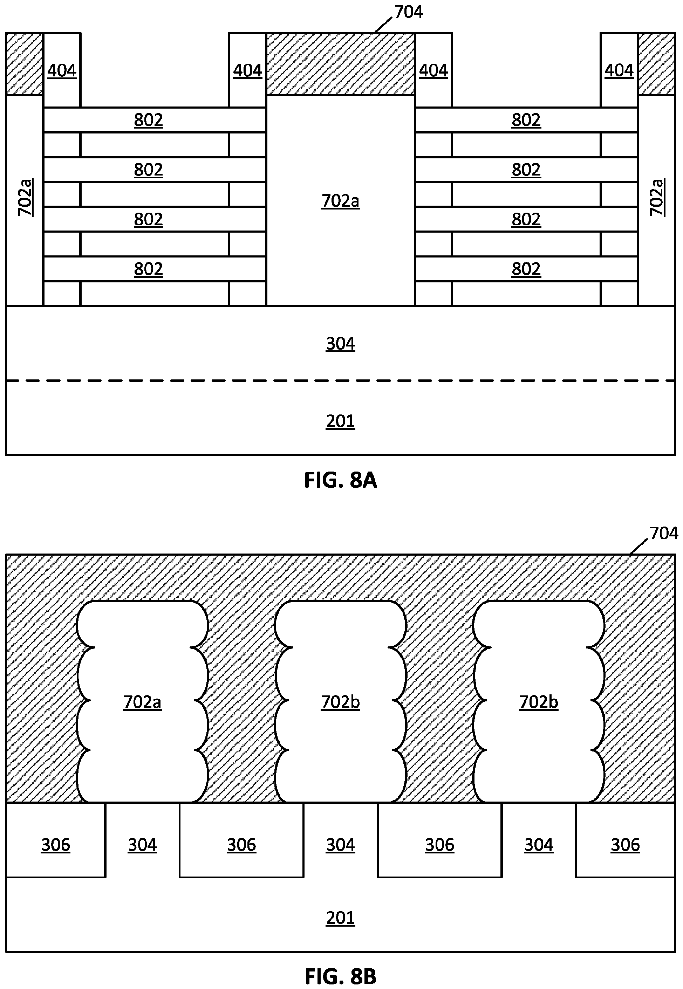

Figures 8A and 8B depict cross-section views of the structure shown in Figures 7A and 7B, respectively, following the removal of sacrificial gates 402 and sacrificial layers 202, according to some embodiments. In examples where gate masking layers are still present, they would be removed at this time. Once sacrificial gates 402 are removed, the fins extending between spacer structures 404 are exposed.

In the example where the fins include alternating semiconductor layers, sacrificial layers 202 are selectively removed to leave behind nanoribbons 802 that extend between corresponding source or drain regions 702a/702b. Each vertical set of nanoribbons 802 represents the semiconductor region (or channel region) of a different semiconductor device. Note that nanoribbons 802 may have any geometry and the use of the term nanoribbon is not intended to exclude any particular geometries usable for a gate-all-around channel region (such as nanowires). In other embodiments, nanoribbons 802 of a given channel region may be a single fin structure, so as to provide a double-gate or tri-gate configuration. In still other embodiments, nanoribbons 802 of a given channel region may be nanosheets extending laterally (out of page) from a dielectric wall, so as to provide a forksheet configuration. Sacrificial gates 402 and sacrificial layers 202 may be removed using the same isotropic etching process or different isotropic etching processes.

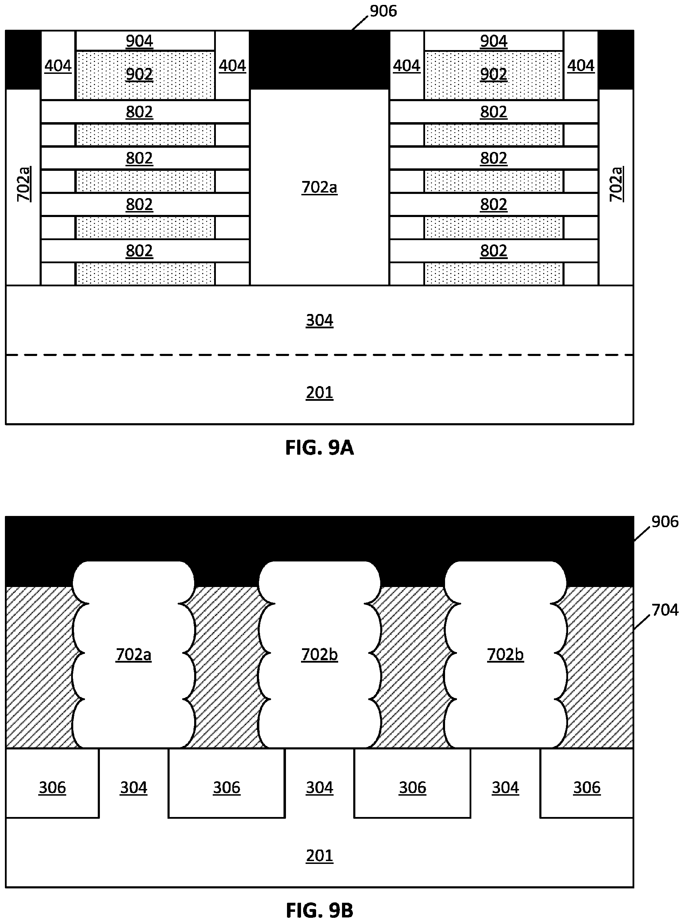

Figures 9A and 9B depict cross-section views of the structure shown in Figures 8A and 8B, respectively, following the formation of gate structures 902, which includes a gate dielectric and a gate electrode, subsequent gate caps 904, and frontside contacts 906, according to some embodiments. The gate dielectric may be first formed around nanoribbons 802 prior to the formation of the gate electrode, which may include one or more conductive layers. The gate dielectric may include any gate dielectric material (such as silicon dioxide, and/or a high-k dielectric material). Examples of high-k dielectric materials include, for instance, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate, to provide some examples. According to some embodiments, the gate dielectric includes a layer of hafnium oxide with a thickness between about 1 nm and about 5 nm. In some embodiments, the gate dielectric may include one or more silicates (e.g., titanium silicate, tungsten silicate, niobium silicate, and silicates of other transition metals). In some cases, the gate dielectric includes a first layer on nanoribbons 802, and a second layer on the first layer. The first layer can be, for instance, an oxide of the semiconductor material of nanoribbons 802 (e.g., silicon dioxide) and the second layer can be a high-k dielectric material (e.g., hafnium oxide).

The one or more conductive layers that make up the gate electrode may be deposited using electroplating, electroless plating, CVD, PECVD, ALD, or PVD, to name a few examples. In some embodiments, the gate electrode includes doped polysilicon, a metal, or a metal alloy. Example metals or metal alloys include aluminum, tungsten, cobalt, molybdenum, ruthenium, titanium, tantalum, copper, and carbides and nitrides thereof. The gate electrode may include, for instance, a metal fill material along with one or more workfunction layers, resistance-reducing layers, and/or barrier layers. The workfunction layers can include, for example, p-type workfunction materials (e.g., titanium nitride) for PMOS gates, or n-type workfunction materials (e.g., titanium aluminum carbide) for NMOS gates.

Gate cap 904 may be formed by first recessing the gate electrode and filling the recess with a dielectric material. The dielectric material may then be polished such that its top surface is substantially coplanar with a top surface of spacer structures 404.

According to some embodiments, frontside contacts 906 may include any conductive material, such as tungsten, molybdenum, cobalt, titanium, tantalum, or ruthenium, or any alloys thereof, for making electrical contact with the underlying source or drain regions 702a/702b. As seen in the cross section of Figure 9B, a portion of dielectric fill 704 is recessed to expose at least the top surfaces of source or drain regions 702a/702b and frontside contact 906 is formed within the recess using any suitable metal deposition process. According to some embodiments, frontside contact 906 includes one or more silicide (or germanide, as the case may be) layers directly on the exposed surfaces of source or drain regions 702a/702b. Frontside contact 906 may extend along the source/drain trench on any number of source or drain regions 702a/702b.

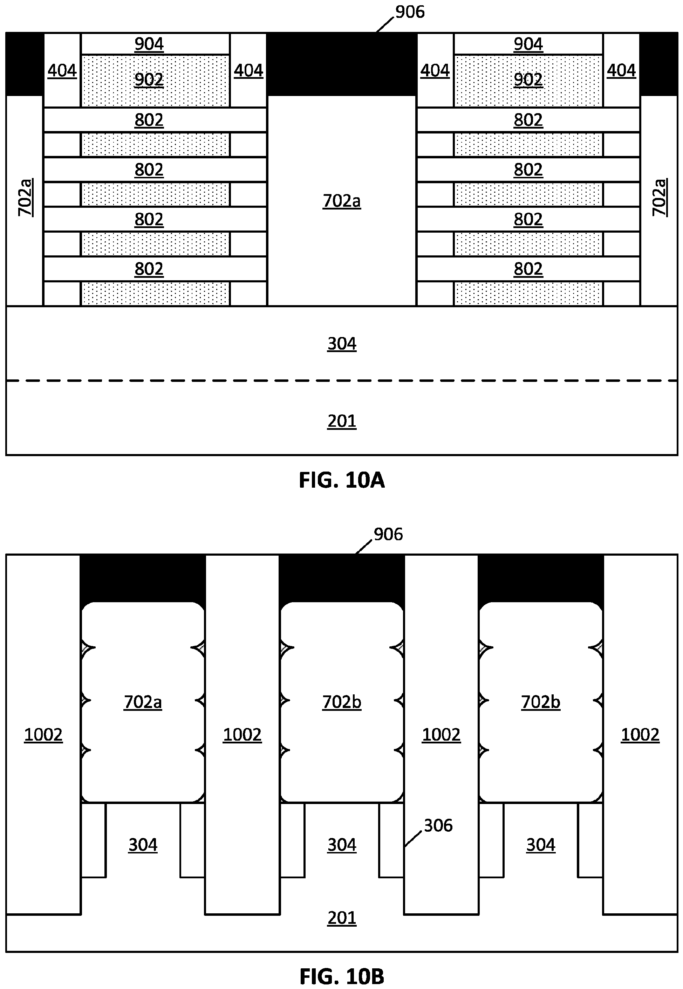

Figures 10A and 10B depict cross-section views of the structure shown in Figures 9A and 9B, respectively, following the formation of dielectric walls 1002 extending in the first direction between devices, according to some embodiments. Dielectric walls 1002 extend to a depth at least through an entire thickness of gate structures 902 to isolate the gate structures along the second direction. In some embodiments, dielectric walls 1002 extend into at least a portion of dielectric fill 306 or through an entire thickness of dielectric fill 306. In some embodiments, dielectric walls 1002 extend entirely through dielectric fill 306 and into a portion of substrate 201.

According to some embodiments, dielectric walls 1002 may be formed by first forming corresponding gate cut recesses through gate cap 904, contact 906 and gate structures 902 using any metal gate etch process that iteratively etches through portions of the gate electrode while simultaneously protecting the sidewalls of the recess from lateral etching to provide a high height-to-width aspect ratio recess (e.g., aspect ratio of 5:1 or higher, or 10:1 or higher). As shown in Figure 10B, the gate cut recesses extend in the first direction through multiple gate trenches and source/drain trenches to isolate adjacent gate structures and source or drain regions. The gate cut recesses may be filled with one or more dielectric materials to form dielectric walls 1002. For example, dielectric walls 1002 may include only silicon dioxide or silicon nitride or silicon carbide. In some examples, dielectric walls 1002 include a first dielectric layer deposited first and a second dielectric layer or dielectric fill formed on the first dielectric layer. The first dielectric layer may include a high-k dielectric material (e.g., materials with a dielectric constant higher than that of silicon oxide or higher than 3.9) while the second dielectric layer may include a low-k dielectric material (e.g. materials with a dielectric constant equal to or lower than that of silicon oxide, such as porous silicon oxide, or equal to or lower than 3.9). In the illustrated example, dielectric walls 1002 separate each of source or drain regions 702a/702b along the second direction along with their associated frontside contacts 906. In some examples where devices are closely packed, dielectric walls 1002 may contact one or more sidewalls of source or drain regions 702a/702b.

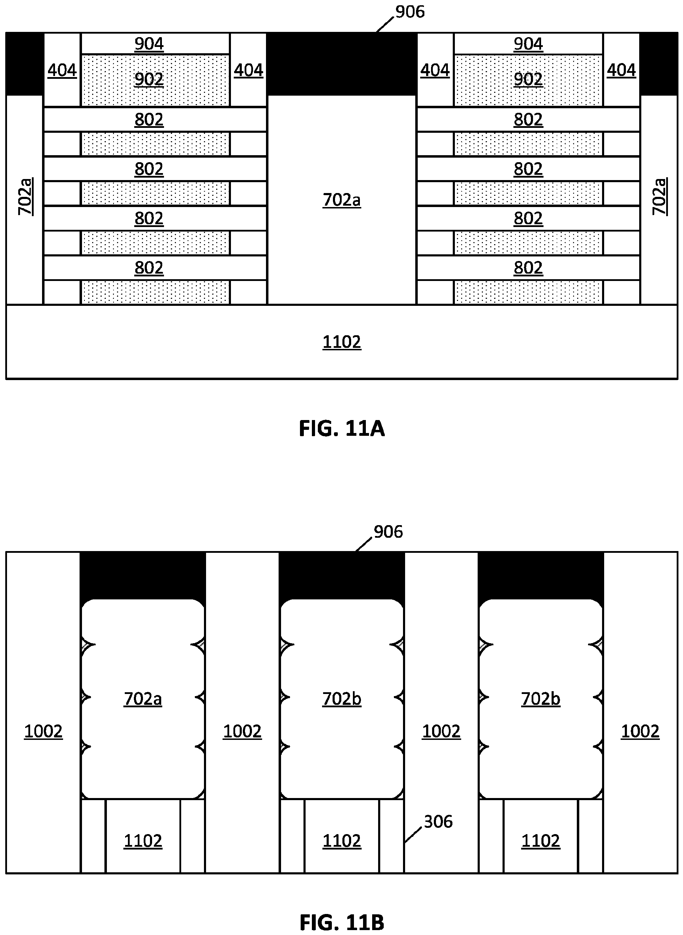

Figures 11A and 11B depict cross-section views of the structure shown in Figures 10A and 10B, respectively, following the removal of substrate 201 from the backside, which exposes subfin regions 304 and the bottom surface of dielectric fill 306, according to some embodiments. The subfin regions may be removed and replaced with any number of dielectric materials to form a dielectric base layer 1102 beneath the semiconductor devices. Dielectric base layer 1102 may include any suitable dielectric material, such as silicon dioxide, and may be polished on the backside such that its bottom surface is substantially coplanar with the bottom surface of dielectric fill 306 and/or dielectric walls 1002.

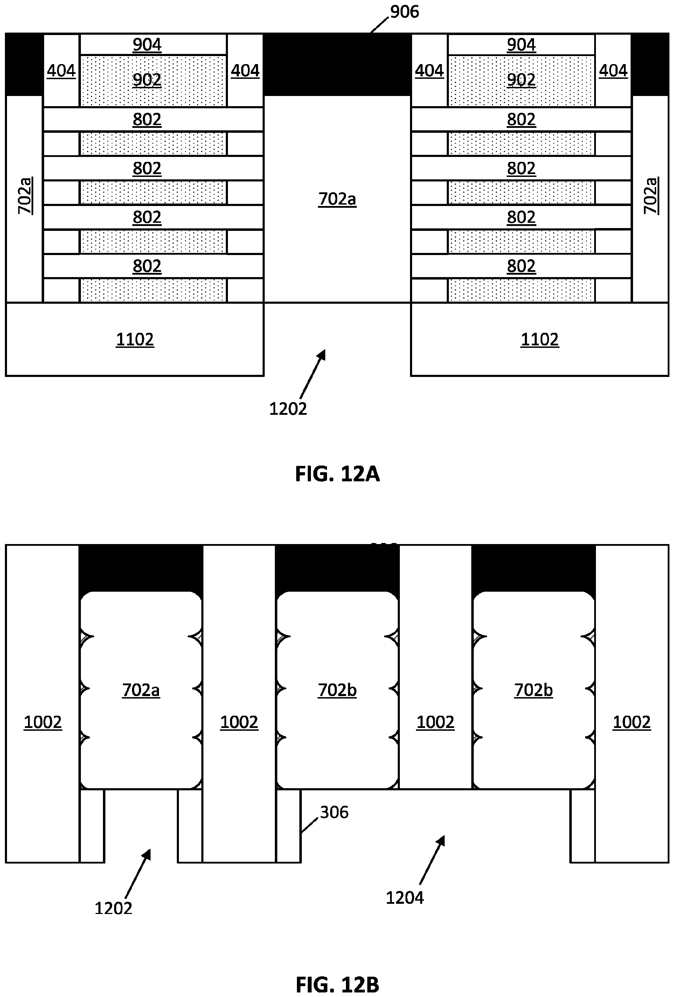

Figures 12A and 12B depict cross-section views of the structure shown in Figures 11A and 11B, respectively, following the formation of one or more backside recesses to expose the bottom surfaces of any number of source or drain regions 702a/702b, according to some embodiments. In the illustrated example, a first backside recess 1202 is formed through base dielectric layer 1102 to expose a single source or drain region 702a and a second backside recess 1204 is formed through base dielectric layer 1102 and through a portion of dielectric wall 1002 to expose more than one source or drain region 702b. Any suitable lithography process using a patterned mask layer on the backside along with an anisotropic etching process may be used to form first backside recess 1202 and second backside recess 1204. In some other embodiments, a sacrificial material is removed from the backside to leave behind first backside recess 1202 and second backside recess 1204. Portions of sacrificial fill 306 may remain along sidewalls of the backside recesses 1202/1204.

According to some embodiments, a given backside surface area of each of source or drain regions 702a/702b is exposed within the corresponding first backside recess 1202 or second backside recess 1204. This exposed surface area may be small enough to cause undesirably high backside contact resistance.

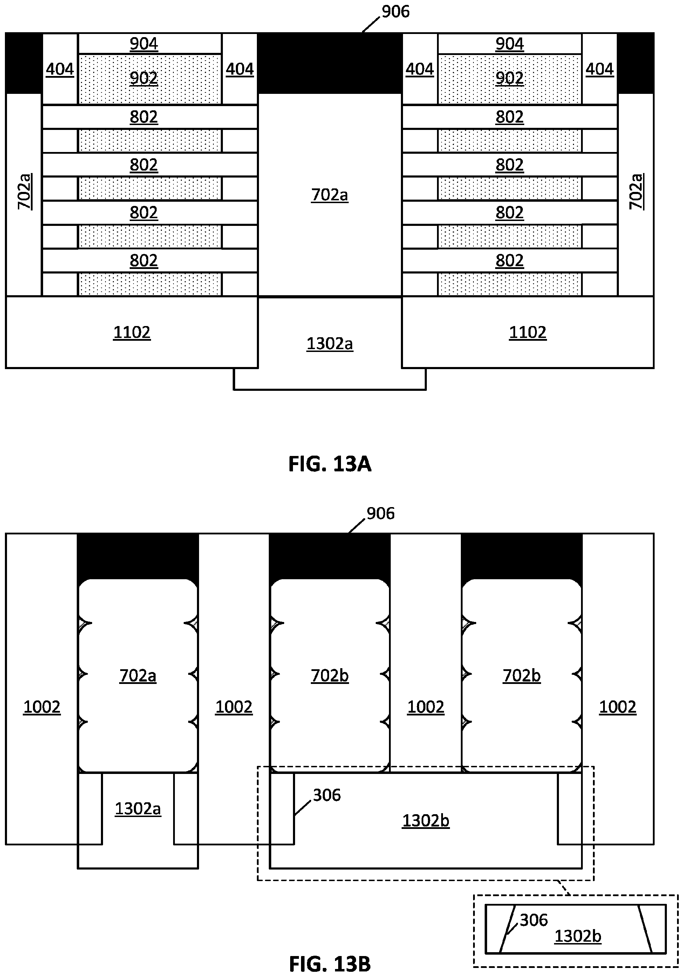

Figures 13A and 13B depict cross-section views of the structure shown in Figures 12A and 12B, respectively, following the growth of backside source or drain regions 1302a/1302b directly beneath the corresponding source or drain regions 702a/702b, according to some embodiments. According to some embodiments, the same n-type or p-type material is grown beneath its corresponding source or drain region. In the illustrated embodiment, backside source or drain region 1302a is a n-type material to match the n-type material of source or drain region 702a and backside source or drain region 1302b is a p-type material to match the p-type material of source or drain regions 702b. Since a new epitaxial growth process is performed to create backside source or drain regions 1302a/1302b, a seam or noticeable difference in grain structure may be present at the boundary between source or drain region 702a and backside source or drain region 1302a and between source or drain regions 702b and backside source or drain region 1302b. Note that in this example, backside source or drain region 1302b connects across two different source or drain regions 702b. Further note that the shape (e.g., faceting) of the backside epitaxial growth may vary, depending on factors such as width of recess and duration of deposition process.

According to some embodiments, backside source or drain regions 1302a/1302b grow outward from backside recesses 1202/1204 to expand the available contact surface area. In some examples, backside source or drain regions 1302a/1302b grow beyond the bottom surface of dielectric fill 306 to create more contact surface area on the exposed bottom surface of backside source or drain regions 1302a/1302b. In some examples, backside source or drain regions 1302a/1302b remain within the backside recesses 1202/1204, but the contact surface area is still expanded due to the tapering of backside recesses 1202/1204. In some such cases, excess epi can be removed via a planarization process (e.g., CMP), so that backside source or drain regions 1302a/1302b are coplanar with backside recesses 1202/1204, as shown in the dashed pull-out. According to some embodiments, backside source or drain regions 1302a/1302b have a higher n-type or p-type dopant concentration compared to their corresponding source or drain regions 702a/702b. For example, a n-type frontside source or drain region 702a may have a dopant concentration between about 4×10²⁰ - 6×10²⁰ cm⁻³ while a n-type backside source or drain region 1302a may have a dopant concentration between about 7×10²⁰ - 8×10²⁰ cm⁻³. A p-type frontside source or drain region 702b may have a dopant concentration between about 2×10²¹ - 3×10²¹ cm⁻³ while a p-type backside source or drain region 1302b may have a dopant concentration between about 3×10²¹ - 4×10²¹ cm⁻³.

Figures 14A and 14B depict cross-section views of the structure shown in Figures 13A and 13B, respectively, following the formation of backside contacts 1402 on the bottom surfaces of backside source or drain regions 1302a/1302b, according to some embodiments. Backside contacts 1402 may be substantially similar to frontside contacts 906, and may include the same conductive material. According to some embodiments, backside contacts 1402 are formed through a backside dielectric layer 1404 formed on the bottom surface of base dielectric layer 1102. Backside dielectric layer 1404 may include any dielectric material, such as the same dielectric material as base dielectric layer 1102. Due to the presence of backside source or drain regions 1302a/1302b, more backside contact surface area is provided for the entire source or drain structure at the interface between backside source or drain regions 1302a/1302b and backside contacts 1402.

As noted above, the epitaxial growth of backside source or drain regions 1302a/1302b may not extend out from the backside recesses. Figures 14A' and 14B' illustrate an example structure where backside source or drain regions 1302a/1302b grow to only partially fill the corresponding backside recesses. In such examples, backside contacts 1402 may be formed within a remaining portion of the backside recesses and polished such that a bottom surface of backside contacts 1402 is substantially coplanar with a bottom surface of base dielectric layer 1102 and/or dielectric fill 306. Due to the natural taper of the sidewalls of the backside recesses, an increase in the backside contact area still occurs when backside source or drain regions 1302a/1302b are full within the backside recesses.

Figure 15 illustrates an example embodiment of a chip package 1500, in accordance with an embodiment of the present disclosure. As can be seen, chip package 1500 includes one or more dies 1502. One or more dies 1502 may include at least one integrated circuit having semiconductor devices, such as any of the semiconductor devices disclosed herein. One or more dies 1502 may include any other circuitry used to interface with other devices formed on the dies, or other devices connected to chip package 1500, in some example configurations.

As can be further seen, chip package 1500 includes a housing 1504 that is bonded to a package substrate 1506. The housing 1504 may be any standard or proprietary housing, and may provide, for example, electromagnetic shielding and environmental protection for the components of chip package 1500. The one or more dies 1502 may be conductively coupled to a package substrate 1506 using connections 1508, which may be implemented with any number of standard or proprietary connection mechanisms, such as solder bumps, ball grid array (BGA), pins, or wire bonds, to name a few examples. Package substrate 1506 may be any standard or proprietary package substrate, but in some cases includes a dielectric material having conductive pathways (e.g., including conductive vias and lines) extending through the dielectric material between the faces of package substrate 1506, or between different locations on each face. In some embodiments, package substrate 1506 may have a thickness less than 1 millimeter (e.g., between 0.1 millimeters and 0.5 millimeters), although any number of package geometries can be used. Additional conductive contacts 1512 may be disposed at an opposite face of package substrate 1506 for conductively contacting, for instance, a printed circuit board (PCB). One or more vias 1510 extend through a thickness of package substrate 1506 to provide conductive pathways between one or more of connections 1508 to one or more of contacts 1512. Vias 1510 are illustrated as single straight columns through package substrate 1506 for ease of illustration, although other configurations can be used (e.g., damascene, dual damascene, through-silicon via, or an interconnect structure that meanders through the thickness of substrate 1506 to contact one or more intermediate locations therein). In still other embodiments, vias 1510 are fabricated by multiple smaller stacked vias, or are staggered at different locations across package substrate 1506. In the illustrated embodiment, contacts 1512 are solder balls (e.g., for bump-based connections or a ball grid array arrangement), but any suitable package bonding mechanism may be used (e.g., pins in a pin grid array arrangement or lands in a land grid array arrangement). In some embodiments, a solder resist is disposed between contacts 1512, to inhibit shorting.

In some embodiments, a mold material 1514 may be disposed around the one or more dies 1502 included within housing 1504 (e.g., between dies 1502 and package substrate 1506 as an underfill material, as well as between dies 1502 and housing 1504 as an overfill material). Although the dimensions and qualities of the mold material 1514 can vary from one embodiment to the next, in some embodiments, a thickness of mold material 1514 is less than 1 millimeter. Example materials that may be used for mold material 1514 include epoxy mold materials, as suitable. In some cases, the mold material 1514 is thermally conductive, in addition to being electrically insulating.

### Methodology

Figure 16 is a flow chart of a method 1600 for forming at least a portion of an integrated circuit, according to an embodiment. Various operations of method 1600 may be illustrated in Figures 2A - 14A and 2B - 14B. However, the correlation of the various operations of method 1600 to the specific components illustrated in the aforementioned figures is not intended to imply any structural and/or use limitations. Rather, the aforementioned figures provide one example embodiment of method 1600. Other operations may be performed before, during, or after any of the operations of method 1600. For example, method 1600 does not explicitly describe various standard processes that are usually performed to form transistor structures. Some of the operations of method 1600 may be performed in a different order than the illustrated order.

Method 1600 begins with operation 1602 where a plurality of parallel semiconductor fins are formed, according to some embodiments. The semiconductor material in the fins may be formed from a substrate such that the fins are an integral part of the substrate (e.g., etched from a bulk silicon substrate). Alternatively, the fins can be formed of material deposited onto an underlying substrate. In one such example case, a blanket layer of silicon germanium (SiGe) can be deposited onto a silicon substrate, and then patterned and etched to form a plurality of SiGe fins extending from that substrate. In another such example, non-native fins can be formed in a so-called aspect ratio trapping based process, where native fins are etched away so as to leave fin-shaped trenches which can then be filled with an alternative semiconductor material (e.g., group IV or III-V material). In still other embodiments, the fins include alternating layers of material (e.g., alternating layers of silicon and SiGe) that facilitates forming of nanowires and nanoribbons during a gate forming process where one type of the alternating layers are selectively etched away so as to liberate the other type of alternating layers within the channel region, so that a gate-all-around (GAA) process can then be carried out. Again, the alternating layers can be blanket deposited and then etched into fins, or deposited into fin-shaped trenches. The fins may also include a cap structure over each fin that is used to define the locations of the fins during, for example, an RIE process. The cap structure may be a dielectric material, such as silicon nitride.

Method 1602 continues with operation 1604 where a dielectric layer is formed around subfin portions of the one or more fins. In some embodiments, the dielectric layer extends between each pair of adjacent parallel fins and runs lengthwise in the same direction as the fins. In some embodiments, the anisotropic etching process that forms the fins also etches into a portion of the substrate and the dielectric layer may be formed within the recessed portions of the substrate. Accordingly, the dielectric layer acts as shallow trench isolation (STI) between adjacent fins. The dielectric layer may be any suitable dielectric material, such as silicon dioxide.

Method 1600 continues with operation 1606 where sacrificial gates are formed over the fins. The sacrificial gates may be patterned using gate masking layers in strips that run orthogonally over the fins and parallel to one another (e.g., forming a cross-hatch pattern). The gate masking layers may be any suitable hard mask material, such as CHM or silicon nitride. The sacrificial gates themselves may be formed from any suitable material that can be selectively removed at a later time without damaging the semiconductor material of the fins. In one example, the sacrificial gates include polysilicon.

According to some embodiments, spacer structures are also formed on sidewalls of at least the sacrificial gates. The spacer structures may be deposited and then etched back such that the spacer structures remain mostly only on sidewalls of any exposed structures. In some cases, spacer structures may also be formed along sidewalls of the exposed fins running orthogonally between the strips of sacrificial gates. According to some embodiments, the spacer structures may be any suitable dielectric material, such as silicon nitride or silicon oxynitride.

Method 1600 continues with operation 1608 where source or drain regions are formed at opposite ends of the fins. Any exposed portions of the fins not covered by the sacrificial gates or spacer structures may be removed using any anisotropic etching process, such as reactive ion etching (RIE). Once the exposed fins have been removed, the source or drain regions may be formed in the areas that had been previously occupied by the exposed fins between the spacer structures. According to some embodiments, the source or drain regions are epitaxially grown from the exposed semiconductor material of the fins (or nanoribbons, nanowires or nanosheets, as the case may be) along the exterior walls of the spacer structures. In some example embodiments, the source or drain regions are NMOS source or drain regions (e.g., epitaxial silicon) or PMOS source or drain regions (e.g., epitaxial SiGe). A dielectric fill may formed between and over the source or drain regions along a given source/drain trench. The dielectric fill may be any suitable dielectric material, such as silicon oxide. In some examples, the dielectric fill extends over the source or drain regions up to and planar with a top surface of the spacer structures. The dielectric fill also acts as an electrical insulator between adjacent source or drain regions, although some adjacent source or drain regions may have merged together during their growth.

Method 1600 continues with operation 1610 where gate structures are formed over the semiconductor material of the various semiconductor fins. The sacrificial gates are first removed along with any sacrificial layers within the exposed fins between the spacer structures (in the case of GAA structures). The gate structures may then be formed in place of the sacrificial gates. The gate structures may each include both a gate dielectric and a gate electrode. The gate dielectric is first formed over the exposed semiconductor regions between the spacer structures followed by forming the gate electrode within the remainder of the trench between the spacer structures, according to some embodiments. The gate dielectric may include any number of dielectric layers deposited using a CVD process, such as ALD. The gate electrode can include any conductive material, such as a metal, metal alloy, or polysilicon. The gate electrode may be deposited using electroplating, electroless plating, CVD, ALD, PECVD, or PVD, to name a few examples.

Method 1600 continues with operation 1612 where the substrate is removed from the backside of the structure to expose the bottom surface of the subfin portions and/or the bottom surface of the dielectric layer adjacent to the subfin portions. The substrate may be removed using any number of isotropic etching, polishing, or grinding operations. The subfin portions may also be removed and replaced with any suitable dielectric material(s), such as silicon dioxide.

Method 1600 continues with operation 1614 where a recess is formed through the dielectric material(s) on the backside to expose the bottom surface of a first source or drain region. The first source or drain region may be any n-type or p-type source or drain region and may represent more than one adjacent source or drain region. The recess may be formed using any suitable anisotropic etching technique, such as RIE. According to some embodiments, the recess may have sidewalls that taper inwards towards the exposed surface of the first source or drain.

Method 1600 continues with operation 1616 where a second source or drain region is formed within the recess and on a bottom surface of the first source or drain region. The second source or drain region may be epitaxially grown from the exposed bottom surface of the first source or drain region. Since a new epitaxial growth process is performed to create the second source or drain region, a seam or noticeable difference in grain structure may be present at the boundary between the first source or drain region and the second source or drain region. In some examples, the second source or drain region may grow across two or more source or drain regions.

According to some embodiments, the second source or drain region expands the available contact area beyond what was available for the first source or drain region. In some examples, the second source or drain region grows beyond the bottom surface of the dielectric layer (out of the recess) to create more contact surface area on the exposed bottom surface of the second source or drain region. In some examples, the second source or drain region remains within the backside recess, but the contact surface area is still expanded due to the inward taper of the backside recess sidewalls. According to some embodiments, the second source or drain region has a higher n-type or p-type dopant concentration compared to the first source or drain region.

Method 1600 continues with operation 1618 where a backside contact is formed on any exposed surface of the second source or drain region. The backside contact may include any suitable conductive material, such as cobalt, ruthenium, molybdenum, or tungsten. According to some embodiments, the backside contact is part of a backside interconnect structure to connect the second source or drain region and the first source or drain region to a power or ground rail.

### Example System

FIG. 17 is an example computing system implemented with one or more of the integrated circuit structures as disclosed herein, in accordance with some embodiments of the present disclosure. As can be seen, the computing system 1700 houses a motherboard 1702. The motherboard 1702 may include a number of components, including, but not limited to, a processor 1704 and at least one communication chip 1706, each of which can be physically and electrically coupled to the motherboard 1702, or otherwise integrated therein. As will be appreciated, the motherboard 1702 may be, for example, any printed circuit board (PCB), whether a main board, a daughterboard mounted on a main board, or the only board of system 1700, etc.

Depending on its applications, computing system 1700 may include one or more other components that may or may not be physically and electrically coupled to the motherboard 1702. These other components may include, but are not limited to, volatile memory (e.g., DRAM), non-volatile memory (e.g., ROM), a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth). Any of the components included in computing system 1700 may include one or more integrated circuit structures or devices configured in accordance with an example embodiment (e.g., a module including one or more semiconductor devices that include a backside source or drain region on a frontside source or drain region to improve backside contact area, as variously provided herein). In some embodiments, multiple functions can be integrated into one or more chips (e.g., for instance, note that the communication chip 1706 can be part of or otherwise integrated into the processor 1704).

The communication chip 1706 enables wireless communications for the transfer of data to and from the computing system 1700. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 1706 may implement any of a number of wireless standards or protocols, including, but not limited to, Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing system 1700 may include a plurality of communication chips 1706. For instance, a first communication chip 1706 may be dedicated to shorter range wireless communications such as Wi-Fi and Bluetooth and a second communication chip 1706 may be dedicated to longer range wireless communications such as GPS, EDGE, GPRS, CDMA, WiMAX, LTE, Ev-DO, and others.

The processor 1704 of the computing system 1700 includes an integrated circuit die packaged within the processor 1704. In some embodiments, the integrated circuit die of the processor includes onboard circuitry that is implemented with one or more semiconductor devices as variously described herein. The term "processor" may refer to any device or portion of a device that processes, for instance, electronic data from registers and/or memory to transform that electronic data into other electronic data that may be stored in registers and/or memory.

The communication chip 1706 also may include an integrated circuit die packaged within the communication chip 1706. In accordance with some such example embodiments, the integrated circuit die of the communication chip includes one or more semiconductor devices as variously described herein. As will be appreciated in light of this disclosure, note that multi-standard wireless capability may be integrated directly into the processor 1704 (e.g., where functionality of any chips 1706 is integrated into processor 1704, rather than having separate communication chips). Further note that processor 1704 may be a chip set having such wireless capability. In short, any number of processor 1704 and/or communication chips 1706 can be used. Likewise, any one chip or chip set can have multiple functions integrated therein.

In various implementations, the computing system 1700 may be a laptop, a netbook, a notebook, a smartphone, a tablet, a personal digital assistant (PDA), an ultra-mobile PC, a mobile phone, a desktop computer, a server, a printer, a scanner, a monitor, a set-top box, an entertainment control unit, a digital camera, a portable music player, a digital video recorder, or any other electronic device that processes data or employs one or more integrated circuit structures or devices formed using the disclosed techniques, as variously described herein.

It will be appreciated that in some embodiments, the various components of the computing system 1700 may be combined or integrated in a system-on-a-chip (SoC) architecture. In some embodiments, the components may be hardware components, firmware components, software components or any suitable combination of hardware, firmware or software.

### Further Example Embodiments

The following examples pertain to further embodiments, from which numerous permutations and configurations will be apparent.

Example 1 is an integrated circuit that includes one or more semiconductor bodies extending in a first direction from a first source or drain region, a gate structure extending over the one or more semiconductor bodies in a second direction different from the first direction, a dielectric layer beneath the gate structure, and a second source or drain region contacting a bottom surface of the first source or drain region, such that a seam is present between the first source or drain region and the second source or drain region. The second source or drain region contacts a sidewall of the dielectric layer.

Example 2 includes the integrated circuit of Example 1, wherein the one or more semiconductor bodies are nanoribbons, nanosheets, or nanowires that comprise germanium, silicon, or any combination thereof.

Example 3 includes the integrated circuit of Example 1 or 2, wherein the first source or drain region and the second source or drain region are both n-type regions or both p-type regions.

Example 4 includes the integrated circuit of any one of Examples 1-3, further comprising a topside contact on a top surface of the first source or drain region such that the topside contact does not contact any portion of the second source or drain region.

Example 5 includes the integrated circuit of any one of Examples 1-4, further comprising a backside contact on a bottom surface of the second source or drain region such that the backside contact does not contact any portion of the first source or drain region.

Example 6 includes the integrated circuit of Example 5, wherein the backside contact comprises any one of tungsten, ruthenium, molybdenum, or cobalt.

Example 7 includes the integrated circuit of Example 5 or 6, wherein the backside contact also contacts the sidewall of the dielectric layer.

Example 8 includes the integrated circuit of any one of Examples 5-7, wherein the backside contact is fully beneath the dielectric layer.

Example 9 includes the integrated circuit of Example 8, wherein the first source or drain region is fully above the dielectric layer.

Example 10 includes the integrated circuit of any one of Examples 1-9, wherein the second source or drain region extends below a bottom surface of the dielectric layer.

Example 11 includes the integrated circuit of any one of Examples 1-10, wherein the first direction is orthogonal to the second direction.

Example 12 includes the integrated circuit of any one of Examples 1-11, wherein the one or more semiconductor bodies are one or more first semiconductor bodies, and the integrated circuit further comprises one or more second semiconductor bodies extending in the first direction from a third source or drain region adjacent to the first source or drain region along the second direction, wherein the second source or drain region further extends from a bottom of the third source or drain region.

Example 13 includes the integrated circuit of Example 12, wherein a seam is present between the third source or drain region and the second source or drain region.

Example 14 includes the integrated circuit of any one of Examples 1-13, wherein a seam is present between the first source or drain region and the second source or drain region.

Example 15 includes the integrated circuit of any one of Examples 1-14, wherein the second source or drain region has a higher n-type dopant concentration or a higher p-type dopant concentration compared to the first source or drain region.

Example 16 is a printed circuit board that includes the integrated circuit of any one of Examples 1-15.

Example 17 is an electronic device that includes a chip package having one or more dies. At least one of the one or more dies includes a semiconductor device having one or more semiconductor bodies extending in a first direction from a first source or drain region, and a gate structure extending over the one or more semiconductor bodies in a second direction different from the first direction, a dielectric layer beneath the gate structure, and a second source or drain region contacting a bottom surface of the first source or drain region. A seam is present between the first source or drain region and the second source or drain region. The second source or drain region contacts a sidewall of the dielectric layer.

Example 18 includes the electronic device of Example 17, wherein the one or more semiconductor bodies are nanoribbons, nanosheets, or nanowires that comprise germanium, silicon, or any combination thereof.

Example 19 includes the electronic device of Example 17 or 18, wherein the first source or drain region and the second source or drain region are both n-type regions or both p-type regions.

Example 20 includes the electronic device of any one of Examples 17-19, wherein the at least one of the one or more dies further comprises a topside contact on a top surface of the first source or drain region such that the topside contact does not contact any portion of the second source or drain region.

Example 21 includes the electronic device of any one of Examples 17-20, wherein the at least one of the one or more dies further comprises a backside contact on a bottom surface of the second source or drain region such that the backside contact does not contact any portion of the first source or drain region.

Example 22 includes the electronic device of Example 21, wherein the backside contact comprises any one of tungsten, ruthenium, molybdenum, or cobalt.

Example 23 includes the electronic device of Example 21 or 22, wherein the backside contact also contacts the sidewall of the dielectric layer.

Example 24 includes the electronic device of any one of Examples 21-23, wherein the backside contact is fully beneath the dielectric layer.

Example 25 includes the electronic device of any one of Examples 17-24, wherein the second source or drain region extends below a bottom surface of the dielectric layer.

Example 26 includes the electronic device of any one of Examples 17-25, wherein the first direction is orthogonal to the second direction.

Example 27 includes the electronic device of any one of Examples 17-26, wherein the one or more semiconductor bodies are one or more first semiconductor bodies, and the at least one of the one or more dies further comprises one or more second semiconductor bodies extending in the first direction from a third source or drain region adjacent to the first source or drain region along the second direction, wherein the second source or drain region further contacts a bottom surface of the third source or drain region such that a seam is present between the third source or drain region and the second source or drain region.

Example 28 includes the electronic device of any one of Examples 17-27, wherein the second source or drain region has a higher n-type dopant concentration or a higher p-type dopant concentration compared to the first source or drain region.

Example 29 includes the electronic device of any one of Examples 17-28, further comprising a printed circuit board, wherein the chip package is attached to the printed circuit board.

Example 30 is a method of forming an integrated circuit. The method includes forming a fin having semiconductor material extending in a first direction over a substrate; forming a dielectric layer adjacent to a bottom portion of the fin; forming a sacrificial gate and spacers on sidewalls of the sacrificial gate, the sacrificial gate extending in a second direction over the fin, the second direction being different from the first direction; removing an exposed portion of the fin adjacent to the sacrificial gate; forming a first source or drain region coupled to an end of the fin; replacing the sacrificial gate with a gate structure; removing the substrate from the backside of the integrated circuit; forming a recess on the backside to expose a bottom surface of the first source or drain region; and forming a second source or drain region within the recess and on the bottom surface of the first source or drain region; and forming a conductive backside contact on a bottom surface of the second source or drain region.

Example 31 includes the method of Example 30, wherein the fin comprises alternating first material layers having silicon and germanium and second material layers having silicon.

Example 32 includes the method of Example 30 or 31, wherein forming the recess on the backside comprises removing a sacrificial material between the dielectric layer from the backside to expose the recess.

Example 33 includes the method of Example 30 or 31, wherein forming the recess on the backside comprises etching through a portion of the dielectric layer.

Example 34 includes the method of any one of Examples 30-33, wherein forming the second source or drain region comprises epitaxially growing the second source or drain region on the first source or drain region such that the second source or drain region spills out from the recess.

Example 35 includes the method of any one of Examples 30-34, wherein forming the first source or drain region comprises epitaxially growing the first source or drain region from the end of the fin.

Example 36 includes the method of any one of Examples 30-35, wherein the second source or drain region has a higher n-type dopant concentration or a higher p-type dopant concentration compared to the first source or drain region.

Example 37 is an integrated circuit that includes one or more semiconductor bodies extending in a first direction from a first source or drain region, a gate structure extending over the one or more semiconductor bodies in a second direction different from the first direction, a dielectric layer beneath the gate structure, and a second source or drain region contacting a bottom surface of the first source or drain region. The second source or drain region has a higher n-type dopant concentration or a higher p-type dopant concentration compared to the first source or drain region.

Example 38 includes the integrated circuit of Example 37, wherein the one or more semiconductor bodies are nanoribbons, nanosheets, or nanowires that comprise germanium, silicon, or any combination thereof.

Example 39 includes the integrated circuit of Example 37 or 38, wherein the first source or drain region and the second source or drain region are both n-type regions or both p-type regions.

Example 40 includes the integrated circuit of any one of Examples 37-39, further comprising a topside contact on a top surface of the first source or drain region such that the topside contact does not contact any portion of the second source or drain region.

Example 41 includes the integrated circuit of any one of Examples 37-40, further comprising a backside contact on a bottom surface of the second source or drain region such that the backside contact does not contact any portion of the first source or drain region.

Example 42 includes the integrated circuit of Example 41, wherein the backside contact comprises any one of tungsten, ruthenium, molybdenum, or cobalt.

Example 43 includes the integrated circuit of Example 41 or 42, wherein the backside contact also contacts a sidewall of the dielectric layer.

Example 44 includes the integrated circuit of any one of Examples 41-43, wherein the backside contact is fully beneath the dielectric layer.

Example 45 includes the integrated circuit of any one of Examples 37-44, wherein the second source or drain region extends below a bottom surface of the dielectric layer.

Example 46 includes the integrated circuit of any one of Examples 37-45, wherein the first direction is orthogonal to the second direction.

Example 47 includes the integrated circuit of any one of Examples 37-46, wherein the one or more semiconductor bodies are one or more first semiconductor bodies, and the integrated circuit further comprises one or more second semiconductor bodies extending in the first direction from a third source or drain region adjacent to the first source or drain region along the second direction, wherein the second source or drain region further contacts a bottom surface of the third source or drain region and the second source or drain region has a higher n-type dopant concentration or a higher p-type dopant concentration compared to the third source or drain region.

Example 48 includes the integrated circuit of any one of Examples 37-47, wherein a seam is present between the first source or drain region and the second source or drain region.

Example 49 is a printed circuit board that includes the integrated circuit of any one of Examples 37-48.

Example 50 is an integrated circuit that includes one or more semiconductor bodies extending in a first direction from a first source or drain region, a gate structure extending over the one or more semiconductor bodies in a second direction different from the first direction, a dielectric layer beneath the gate structure, and a second source or drain region extending from a bottom of the first source or drain region. The second source or drain region is at least partially laterally between first and second portions of the dielectric layer. The first source or drain region is fully above the dielectric layer.

Example 51 includes the integrated circuit of Example 50, wherein the one or more semiconductor bodies are nanoribbons, nanosheets, or nanowires that comprise germanium, silicon, or any combination thereof.

Example 52 includes the integrated circuit of Example 50 or 51, wherein the first source or drain region and the second source or drain region are both n-type regions or both p-type regions.

Example 53 includes the integrated circuit of any one of Examples 50-52, further comprising a topside contact on a top surface of the first source or drain region such that the topside contact does not contact any portion of the second source or drain region.

Example 54 includes the integrated circuit of any one of Examples 50-53, further comprising a backside contact on a bottom surface of the second source or drain region such that the backside contact does not contact any portion of the first source or drain region.

Example 55 includes the integrated circuit of Example 54, wherein the backside contact comprises any one of tungsten, ruthenium, molybdenum, or cobalt.

Example 56 includes the integrated circuit of Example 54 or 55, wherein the backside contact also contacts the sidewall of the dielectric layer.

Example 57 includes the integrated circuit of Example 56, wherein the sidewall of the dielectric layer is tapered, such that the second source or drain region is also tapered and gets wider as it extends away from the first source or drain region.

Example 58 includes the integrated circuit of Example 56 or 57, wherein the sidewall of the dielectric layer is tapered, such that the backside contact is also tapered and gets wider as it extends away from the second source or drain region.

Example 59 includes the integrated circuit of any one of Examples 54-57, wherein the backside contact is fully beneath the dielectric layer.

Example 60 includes the integrated circuit of any one of Examples 50-59, wherein the second source or drain region extends below a bottom surface of the dielectric layer.

Example 61 includes the integrated circuit of any one of Examples 50-60, wherein the first direction is orthogonal to the second direction.

Example 62 includes the integrated circuit of any one of Examples 50-61, wherein the one or more semiconductor bodies are one or more first semiconductor bodies, and the integrated circuit further comprises one or more second semiconductor bodies extending in the first direction from a third source or drain region adjacent to the first source or drain region along the second direction, wherein the second source or drain region further contacts a bottom surface of the third source or drain region and the second source or drain region has a higher n-type dopant concentration or a higher p-type dopant concentration compared to the third source or drain region.

Example 63 includes the integrated circuit of any one of Examples 50-62, wherein a seam is present between the first source or drain region and the second source or drain region.

Example 64 is a printed circuit board that includes the integrated circuit of any one of Examples 50-63.

The foregoing description of the embodiments of the disclosure has been presented for the purposes of illustration and description. It is not intended to be exhaustive or to limit the disclosure to the precise forms disclosed. Many modifications and variations are possible in light of this disclosure. It is intended that the scope of the disclosure be limited not by this detailed description, but rather by the claims appended hereto.

## Claims

1. An integrated circuit comprising:
one or more semiconductor bodies extending in a first direction from a first source or drain region;
a gate structure extending over the one or more semiconductor bodies in a second direction different from the first direction;
a dielectric layer beneath the gate structure; and
a second source or drain region extending from a bottom of the first source or drain region, wherein the second source or drain region contacts a sidewall of the dielectric layer.

2. The integrated circuit of claim 1, wherein the one or more semiconductor bodies are nanoribbons, nanosheets, or nanowires that comprise germanium, silicon, or any combination thereof.

3. The integrated circuit of claim 1 or 2, wherein the first source or drain region and the second source or drain region are both n-type regions or both p-type regions.

4. The integrated circuit of any one of claims 1 through 3, further comprising a topside contact on a top surface of the first source or drain region such that the topside contact does not contact any portion of the second source or drain region.

5. The integrated circuit of any one of claims 1 through 4, further comprising a backside contact on a bottom surface of the second source or drain region such that the backside contact does not contact any portion of the first source or drain region.

6. The integrated circuit of claim 5, wherein the backside contact comprises any one of tungsten, ruthenium, molybdenum, or cobalt.

7. The integrated circuit of claim 5 or 6, wherein the backside contact also contacts the sidewall of the dielectric layer.

8. The integrated circuit of any one of claims 5 through 7, wherein the backside contact is fully beneath the dielectric layer.

9. The integrated circuit of claim 8, wherein the first source or drain region is fully above the dielectric layer.

10. The integrated circuit of any one of claims 1 through 9, wherein the second source or drain region extends below a bottom surface of the dielectric layer.

11. The integrated circuit of any one of claims 1 through 10, wherein the first direction is orthogonal to the second direction.

12. The integrated circuit of any one of claims 1 through 11, wherein the one or more semiconductor bodies are one or more first semiconductor bodies, and the integrated circuit further comprises one or more second semiconductor bodies extending in the first direction from a third source or drain region adjacent to the first source or drain region along the second direction, wherein the second source or drain region further extends from a bottom of the third source or drain region.

13. The integrated circuit of claim 12, wherein a seam is present between the third source or drain region and the second source or drain region.

14. The integrated circuit of any one of claims 1 through 13, wherein a seam is present between the first source or drain region and the second source or drain region.

15. The integrated circuit of any one of claims 1 through 14, wherein the second source or drain region has a higher n-type dopant concentration or a higher p-type dopant concentration compared to the first source or drain region.
